# EUROPEAN PATENT APPLICATION

(11) **EP 4 770 398 A1**
(43) Date of publication of application: **01.07.2026**
(21) Application number: 24860107.2
(22) Date of filing: 24.06.2024
(51) Int. Cl.: H10K 59/88, G09G 3/32, H10K 59/90, H10K 59/60, H10K 59/121, H10K 59/124, H10K 59/131, H10K 59/80, H10K 59/122

(54) **DISPLAY PANEL AND ELECTRONIC DEVICE COMPRISING SAME**

(30) Priority: 25.08.2023 KR 20230112286; 17.10.2023 KR 20230138999
(71) Applicant: Samsung Display Co., Ltd., Yongin-si, Gyeonggi-do 17113 (KR)
(72) Inventor: KIM, Dong Hyun, Yongin-Si Gyeonggi-do 17113 (KR); KANG, Chul Kyu, Yongin-Si Gyeonggi-do 17113 (KR); JEON, Woong Ki, Yongin-Si Gyeonggi-do 17113 (KR); KIM, Su Jin, Yongin-Si Gyeonggi-do 17113 (KR); MOK, Seon Kyoon, Yongin-Si Gyeonggi-do 17113 (KR)
(74) Representative: Gulde & Partner
(86) International application number: PCT/KR2024/008717
(87) International publication number: WO 2025/048183

(57) **Abstract**

An embodiment of the invention discloses a display panel that includes a substrate in which a transmission area, a dummy area surrounding the transmission area are defined, and a display area surrounding the dummy area, a driving circuit in the display area and including a transistor, a voltage line in the display area and electrically connected to the driving circuit, an insulating layer on the voltage line, a first pixel electrode on the insulating layer, in the display area, a bank layer covering an edge of the first pixel electrode and defining a first opening overlapping the first pixel electrode, an emission layer overlapping the first pixel electrode, an opposing electrode disposed on the emission layer, and a dummy electrode layer on the insulating layer, in the dummy area. The bank layer extends towards the dummy area and defines a plurality of dummy openings overlapping the dummy electrode layer.

## Description

### Technical Field

Embodiments relate to a display panel and an electronic apparatus including the same.

### Background Art

Recently, purposes of display panels are being diversified. In addition, thicknesses and weights of display panels are decreasing, and thus, a range of uses of display panels is widening.

Various functions incorporated into or associated with display panels are being added while areas occupied by display areas in the display panels are increasing. As a method of adding the various functions while enlarging the areas, studies on using a portion of a display area for a function other than a function of displaying images are continuing.

### Disclosure of Invention

### Technical Problem

Embodiments provide structures of a display panel including a transmission area and an electronic apparatus including the display panel.

Additional features will be set forth in part in the description which follows and, in part, will be apparent from the description, or may be learned by practice of the presented embodiments of the disclosure.

### Solution to Problem

In an embodiment of the disclosure, a display panel includes a substrate in which a transmission area, a dummy area surrounding the transmission area, and a display area surrounding the dummy area are defined, a driving circuit disposed in the display area and including a transistor, a voltage line disposed in the display area and electrically connected to the driving circuit, an insulating layer on the voltage line, a first pixel electrode disposed on the insulating layer in the display area, a bank layer covering an edge of the first pixel electrode and defining a first opening overlapping the first pixel electrode, an emission layer overlapping the first pixel electrode through the first opening of the bank layer, an opposing electrode disposed on the emission layer and overlapping the first pixel electrode and the emission layer, and a dummy electrode layer disposed on the insulating layer in the dummy area, where the bank layer extends towards the dummy area and defines a plurality of dummy openings overlapping the dummy electrode layer.

In an embodiment of the disclosure, an electronic apparatus includes the above-described display panel and a component corresponding to the transmission area of the display panel. The component may include a sensor or a camera.

In an embodiment, the display panel may further include a dummy transistor disposed below the dummy electrode layer, where the dummy electrode layer may be electrically insulated from the dummy transistor.

In an embodiment, the voltage line may extend towards the dummy area and a portion of the voltage line may overlap the dummy electrode layer, and the dummy electrode layer may be electrically connected to the voltage line.

In an embodiment, the voltage line may have a same voltage level as a voltage level of the opposing electrode.

In an embodiment, the driving circuit may further include an initialization transistor which is electrically connected to the first pixel electrode and initializes the first pixel electrode, and the voltage line may be electrically connected to the initialization transistor.

In an embodiment, the plurality of dummy openings of the bank layer may include a first dummy opening, a second dummy opening, and a third dummy opening, which overlap different portions of the dummy electrode layer, respectively.

In an embodiment, the display panel may further include a second pixel electrode disposed on the insulating layer in the display area and adjacent to the first pixel electrode while being mutually separated from the first pixel electrode, and a third pixel electrode disposed on the insulating layer in the display area and adjacent to the first pixel electrode and the second pixel electrode while being mutually separated from the first pixel electrode and the second pixel electrode, where the bank layer may further define a second opening and a third opening, where the second opening overlaps the second pixel electrode and the third opening overlaps the third pixel electrode, the first opening and the second opening may be defined in a same column, and the third opening may be defined adjacent to the column of the first opening and the second opening, and the first dummy opening and the second dummy opening may be defined in a same column, and the third dummy opening may be defined adjacent to the column of the first dummy opening and the second dummy opening.

In an embodiment, a size of the first dummy opening and a size of the first opening may be substantially the same as each other, a size of the second dummy opening and a size of the second opening may be substantially the same as each other, and a size of the third dummy opening and a size of the third opening may be substantially the same as each other.

In an embodiment, a size and a shape of the first dummy opening may be different from a size and a shape of the first opening.

In an embodiment, a routing area may be further defined between the transmission area and the dummy area in the substrate and surround the transmission area, where the dummy electrode layer may extend towards the routing area, and the bank layer may further define a fourth dummy opening, a fifth dummy opening, and a sixth dummy opening, which overlap different portions of the dummy electrode layer arranged in the routing area, respectively.

In an embodiment, a size of the first dummy opening, a size of the second dummy opening, and a size of the third dummy opening may be different from each other, a size of the fourth dummy opening and the size of the first dummy opening may be substantially the same as each other, a size of the fifth dummy opening and the size of the second dummy opening may be substantially the same as each other, and a size of the sixth dummy opening and the size of the third dummy opening may be substantially the same as each other.

In an embodiment, the dummy electrode layer may not overlap the transistor in the routing area.

In an embodiment, the display panel may further include a signal line electrically connected to the driving circuit, where the signal line may detour along an edge of the transmission area, in the routing area, and the dummy electrode layer may overlap a detouring portion of the signal line, in the routing area.

In an embodiment, the bank layer may include a light-shielding material.

### Advantageous Effects of Invention

In an embodiment of the disclosure, a reflectance difference between a display area and an intermediate area may be reduced when a display panel is not operated (turned off), and accordingly, the display area and the intermediate area may be prevented from being distinguishably recognized by a user when the display panel is not operated (turned off). Such effects are only examples and the scope of the disclosure is not limited by the above effects.

### Brief Description of Drawings

The above and other features and advantages of illustrative embodiments of the disclosure will be more apparent from the following description taken in conjunction with the accompanying drawings.
FIGS. 1A to 1C are perspective views schematically showing an embodiment of an electronic apparatus.
FIG. 2 is a cross-sectional view of an embodiment of the electronic apparatus taken along line II-II' of FIG. 1C.
FIG. 3 is a plan view showing an embodiment of an excerpt of a portion of a display panel.
FIG. 4 is an equivalent circuit diagram schematically showing an embodiment of a light-emitting diode disposed in a display area and a driving circuit electrically connected to the light-emitting diode.
FIG. 5 is a cross-sectional view showing an embodiment of a portion of a display panel.
FIG. 6 is a plan view showing an embodiment of a portion of a display panel and illustrates a region III of FIG. 3.
FIG. 7 is a plan view showing an embodiment of an excerpt of a region VII shown in FIG. 6 as a display panel.
FIG. 8 is a cross-sectional view of the display panel taken along lines VIIIa-VIIIa' and VIIIb-VIIIb' of FIG. 7.
FIG. 9 is a plan view showing an embodiment of a portion of a display panel and illustrates the region III of FIG. 3.
FIG. 10 is a plan view showing an embodiment of an excerpt of a region X of FIG. 9 as a display panel.
FIG. 11 is a cross-sectional view of an embodiment of the display panel taken along lines XIa-XIa' and XIb-XIb' of FIG. 10.
FIG. 12 is a plan view schematically showing an embodiment of a display panel.
FIG. 13 is a plan view showing a portion of the display panel of FIG. 12.
FIGS. 14A and 14B are each a cross-sectional view showing an embodiment of a portion of a display panel, in an embodiment, taken along line XIV-IXV' of FIG. 13.
FIG. 15 is a plan view schematically illustrating an embodiment of a portion of a display panel.
FIG. 16 is a plan view showing an excerpt of a region XVI of FIG. 15.
FIG. 17 is a cross-sectional view of the region XVI of FIG. 16 taken along line XVII-XVII' of FIG. 16.

### Best Mode for Carrying out the Invention

In an embodiment of the disclosure, a display panel includes a substrate in which a transmission area, a dummy area surrounding the transmission area, and a display area surrounding the dummy area are defined, a driving circuit disposed in the display area and including a transistor, a voltage line disposed in the display area and electrically connected to the driving circuit, an insulating layer on the voltage line, a first pixel electrode disposed on the insulating layer in the display area, a bank layer covering an edge of the first pixel electrode and defining a first opening overlapping the first pixel electrode, an emission layer overlapping the first pixel electrode through the first opening of the bank layer, an opposing electrode disposed on the emission layer and overlapping the first pixel electrode and the emission layer, and a dummy electrode layer disposed on the insulating layer in the dummy area, where the bank layer extends towards the dummy area and defines a plurality of dummy openings overlapping the dummy electrode layer.

In an embodiment of the disclosure, an electronic apparatus includes the above-described display panel and a component corresponding to the transmission area of the display panel. The component may include a sensor or a camera.

### Mode for the Invention

The disclosure may have various modifications and various embodiments, and illustrative embodiments are illustrated in the drawings and are described in detail in the detailed description. Effects and features of the disclosure and methods of achieving the same will become apparent with reference to embodiments described in detail with reference to the drawings. However, the disclosure is not limited to the embodiments described below, and may be implemented in various forms.

Hereinafter, embodiments will be described in detail with reference to the accompanying drawings, and in the following description with reference to the drawings, like reference numerals refer to like elements and redundant descriptions thereof will be omitted.

In the following embodiments, the terms "first" and "second" are not used in a limited sense and are used to distinguish one component from another component.

In the following embodiments, an expression used in the singular encompasses the expression of the plural, unless it has a clearly different meaning in the context.

In the following embodiments, it will be further understood that the terms "comprise" and/or "comprising" used herein specify the presence of stated features or components, but do not preclude the presence or addition of one or more other features or components.

It will be understood that when a layer, region, or element is referred to as being "formed on" another layer, area, or element, it can be directly or indirectly formed on the other layer, region, or element. That is, for example, intervening layers, regions, or elements may be present.

In the drawings, for convenience of description, sizes of components may be exaggerated or reduced. In other words, because sizes and thicknesses of components in the drawings are arbitrarily illustrated for convenience of explanation, the disclosure is not necessarily limited thereto.

When an illustrative embodiment may be implemented differently, a specific process order may be performed differently from the described order. For example, two consecutively described processes may be performed substantially at the same time or performed in an order opposite to the described order.

As used herein, the term "and/or" includes any and all combinations of one or more of the associated listed items. Throughout the disclosure, the expression "at least one of a, b, and c" indicates only a, only b, only c, both a and b, both a and c, both b and c, all of a, b, and c, or variations thereof.

When a layer, region, component, or the like is connected to another layer, region, component, or the like, the layer, the region, the component, or the like may be directly connected thereto and/or may be indirectly connected thereto with an intervening layer, region, component, or the like therebetween. For example, in the specification, when a layer, region, component, or the like is electrically connected to another layer, region, component, or the like, the layer, region, component, or the like may be directly electrically connected thereto and/or may be indirectly electrically connected thereto with an intervening layer, region, component, or the like therebetween.

An x-axis, a y-axis, and a z-axis are not limited to three axes on an orthogonal coordinate system, but may be interpreted in a broad sense including the three axes. For example, the x-axis, the y-axis, and the z-axis may be perpendicular to one another, or may represent different directions that are not perpendicular to one another.

The term "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "substantially" can mean within one or more standard deviations, or within ± 5% of the stated value, for example.

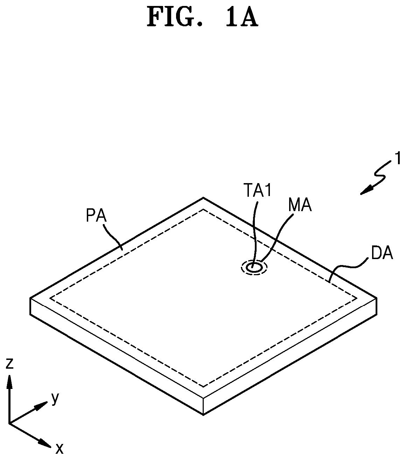

FIGS. 1A to 1C are perspective views schematically showing an embodiment of an electronic apparatus 1.

Referring to FIGS. 1A to 1C, the electronic apparatus 1 is a device which displays a moving image or a still image, and may include a portable electronic apparatus, such as a mobile phone, a smartphone, a laptop computer, a tablet personal computer, a mobile communication terminal, an electronic notebook, an electronic book, a portable multimedia player ("PMP"), a navigation device, or an ultra-mobile personal computer ("UMPC"). The electronic apparatus 1 may be a display for a television, a billboard, or Internet of things ("IoT"). The electronic apparatus 1 may be used for a wearable device, such as a smart watch, a watch phone, a glasses-type display, or a head mounted display ("HMD"). In addition, the electronic apparatus 1 in an embodiment may be used as a panel of a vehicle, a center information display ("CID") disposed on a center fascia or dashboard of a vehicle, a room mirror display replacing a side mirror of a vehicle, or a display disposed on a rear surface of a front seat, as entertainment for a back seat of a vehicle. The electronic apparatus 1 may be bendable, foldable, or rollable.

The electronic apparatus 1 may have a quadrangular shape, e.g., rectangular shape in a plan view. A corner of the electronic apparatus 1 where a side in an x direction and a side in a y direction meet may be formed in a right angle or formed round to have a predetermined curvature. A planar shape of the electronic apparatus 1 is not limited to a rectangle, and may be another polygon, an oval, or an atypical shape.

The electronic apparatus 1 may include a transmission area. In an embodiment, as shown in FIG. 1A, the electronic apparatus 1 may include a first transmission area TA1 and a display area DA surrounding the first transmission area TA1, for example. The electronic apparatus 1 may include an intermediate area MA disposed between the first transmission area TA1 and the display area DA, and the outside of the display area DA, e.g., a peripheral area PA surrounding the display area DA. An entirety of the first transmission area TA1 may be surrounded by the intermediate area MA, an entirety of the intermediate area MA may be surrounded by the display area DA, and an entirety of the display area DA may be surrounded by the peripheral area PA.

Light-emitting diodes are arranged in the display area DA. The display area DA may provide an image by light emitted from the light-emitting diodes. A light-emitting diode for emitting light is not disposed in the first transmission area TA1, the intermediate area MA, and the peripheral area PA.

The first transmission area TA1 may be defined inside the display area DA. In an embodiment, the first transmission area TA1 may be defined at an upper center of the display area DA, as shown in FIG. 1A. In a plan view of the specification, "left," "right," "up," and "down" indicate directions when the electronic apparatus 1 is viewed in a direction perpendicular to the electronic apparatus 1. In an embodiment, "left" indicates a -x direction, "right" indicates a +x direction, "up" indicates a +y direction, and "down" indicates a -y direction, for example.

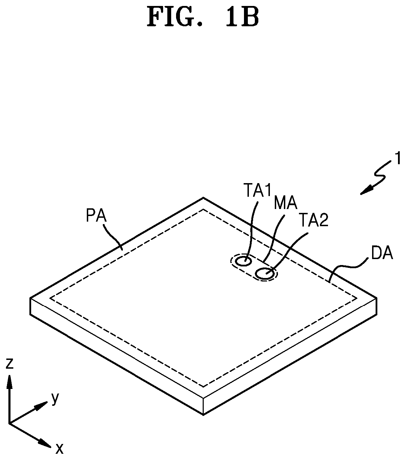

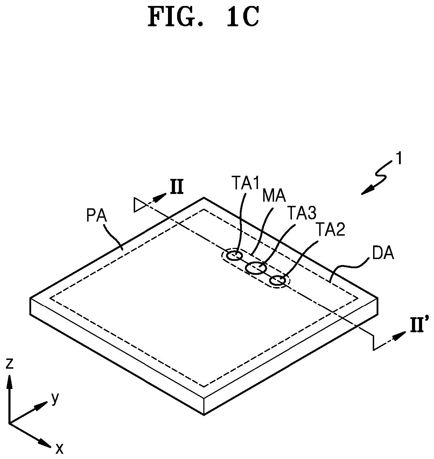

In FIG. 1A, one transmission area is defined, but in another embodiment, there may be a plurality of transmission areas. As shown in FIG. 1B, the electronic apparatus 1 may include two transmission areas. In an embodiment, an entirety of the first transmission area TA1 and a second transmission area TA2 may be surrounded by the intermediate area MA, and an entirety of the intermediate area MA and the first transmission area TA1 and the second transmission area TA2, which are inside the intermediate area MA, may be surrounded by the display area DA, for example. In another embodiment, as shown in FIG. 1C, the electronic apparatus 1 may include three transmission areas. In an embodiment, an entirety of the first transmission area TA1, the second transmission area TA2, and a third transmission area TA3 may be surrounded by the intermediate area MA, and an entirety of the intermediate area MA and the first transmission area TA1, the second transmission area TA2, and the third transmission area TA3, which are inside the intermediate area MA, may be surrounded by the display area DA, for example. A size of one of the first to third transmission areas TA1 to TA3 may be different from a size of another one.

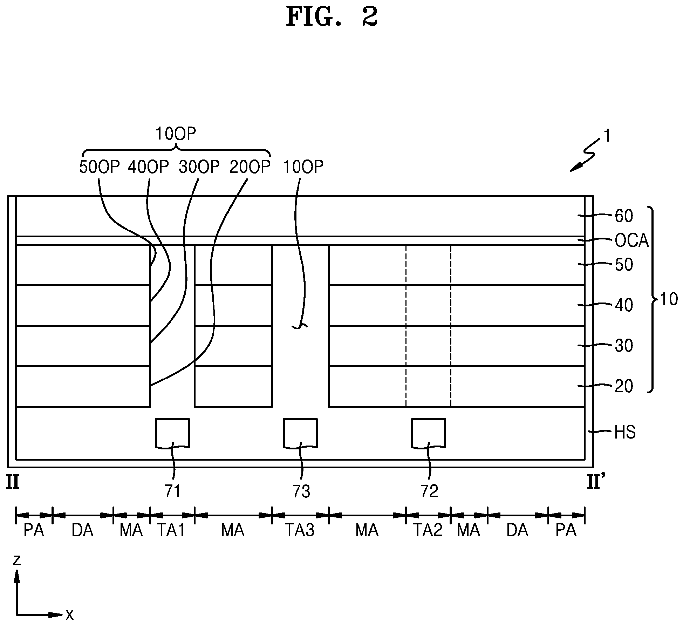

FIG. 2 is a cross-sectional view of an embodiment of the electronic apparatus 1 of FIG. 1C taken along line II-II' of FIG. 1C.

Referring to FIG. 2, the electronic apparatus 1 may include a display panel 10 and a component disposed in a transmission area of the display panel 10. Like the electronic apparatus 1, the display panel 10 may include a transmission area, the intermediate area MA, the display area DA, and the peripheral area PA. In an embodiment, in FIG. 2, the display panel 10 includes three transmission areas, e.g., the first to third transmission areas TA1 to TA3, and the electronic apparatus 1 includes three components, e.g., a first component 71, a second component 72, and a third component 73 respectively corresponding to the first to third transmission areas TA1 to TA3. The display panel 10 and the first to third components 71 to 73 may be accommodated in a housing HS.

The display panel 10 may include a display layer 20, an encapsulation layer 30, an input detection layer (also referred to as an input sensing layer) 40, an optical functional layer 50, and a cover window 60.

The display layer 20 may include light-emitting elements emitting light to display an image, and driving circuits electrically connected to the light-emitting element and including transistors, respectively.

The encapsulation layer 30 may seal the display layer 20. The encapsulation layer 30 may include at least one organic encapsulation layer and at least one inorganic encapsulation layer. In another embodiment, the encapsulation layer 30 may include a glass substrate.

The input detection layer 40 may obtain coordinate information according to external pressure, e.g., a touch event. The input detection layer 40 may include touch electrodes and signal lines (trace lines) connected to the touch electrodes. The input detection layer 40 may be disposed on the encapsulation layer 30. The input detection layer 40 may detect an external input through a mutual cap method and/or a self-cap method.

The optical functional layer 50 may include an antireflection layer. The antireflection layer may reduce reflectance of light (external light) incident from the outside towards the display panel 10 through the cover window 60. The antireflection layer may include a retarder and a polarizer.

In another embodiment, the antireflection layer may include a black matrix and color filters. The color filters may be arranged considering colors of lights respectively emitted from display elements (e.g., light-emitting diodes) of the display layer 20. In another embodiment, the antireflection layer may include a destructive interference structure. The destructive interference structure may include a first reflective layer and a second reflective layer arranged in different layers. First reflective light and second reflective light reflected respectively from the first reflective layer and the second reflective layer may destructively interfere with each other, and accordingly, reflectance of external light may be reduced.

The optical functional layer 50 may include a lens layer. The lens layer may improve light output efficiency of light emitted from the display layer 20 or reduce color deviation. The lens layer may include a layer having a convex or concave lens shape and/or a plurality of layers having different refractive indexes. The optical functional layer 50 may include both or one of the antireflection layer and the lens layer.

An opening 10OP may be defined in the display panel 10. In this regard, FIG. 2 illustrates the display panel 10 including the openings 10OP respectively corresponding to the first transmission area TA1 and the third transmission area TA3. The display layer 20, the encapsulation layer 30, the input detection layer 40, and the optical functional layer 50 define openings 20OP, 30OP, 40OP, and 50OP, respectively, which may overlap each other. The display layer 20, the encapsulation layer 30, the input detection layer 40, and the optical functional layer 50 may not define an opening corresponding to the second transmission area TA2.

The cover window 60 may be disposed on the optical functional layer 50. The cover window 60 may be combined to the optical functional layer 50 through an adhesive layer OCA, such as an optical clear adhesive, disposed therebetween. The cover window 60 may include a glass material or a plastic material. The plastic material may include polyether sulfone, polyacrylate, polyether imide, polyethylene naphthalate, polyethylene terephthalate, polyphenylene sulfide, polyarylate, polyimide, polycarbonate, or cellulose acetate propionate.

The cover window 60 may include a flexible window. In an embodiment, the cover window 60 may include a polyimide window or an ultra-thin glass window, for example.

The first to third transmission areas TA1 to TA3 may be a type of component areas (e.g., a sensor area, a camera area, a speaker area, or the like) where the first to third components 71 to 73 for providing various functions to the electronic apparatus 1 are disposed. The first to third components 71 to 73 may be arranged on a rear surface of the display panel 10, respectively in response to the first to third transmission areas TA1 to TA3.

The first to third components 71 to 73 may include an electronic element. The first to third components 71 to 73 may be an electronic element using light or sound, and the light or sound may penetrate through the first to third transmission areas TA1 to TA3. The electronic element may include a camera capturing an image by receiving light, a sensor measuring a distance by outputting and detecting light or sound, a sensor recognizing a part of a human body, such as an iris, a fingerprint, or a face, a relatively small lamp outputting light, and a speaker outputting sound, for example. The electronic element using light may use light of various wavelength bands, such as visible light, infrared light, or ultraviolet light.

The first to third components 71 to 73 may include different electronic elements from each other. In an embodiment, one of the first to third components 71 to 73 may be a camera for a video conference or capturing an image such as a selfie. One of the remaining two of the first to third components 71 to 73 may be an emitter emitting infrared light and the other one may be a receiver receiving light of infrared light to recognize a part of a human body, for example. As described above, the first to third components 71 to 73 may be electronic elements having different functions.

In another embodiment, when the electronic apparatus 1 is used as a smart watch or a vehicle dashboard, one of the first to third components 71 to 73 may be a member including a clock hand or a needle indicating predetermined information (e.g., a vehicle speed or the like). In this case, an opening may be defined in the cover window 60 unlike shown in FIG. 2 so that a component such as a needle may be externally exposed.

FIG. 2 illustrates three transmission areas, but the disclosure is not limited thereto. In another embodiment, as described above with reference to FIGS. 1A and 1B, the electronic apparatus 1 and/or the display panel 10 may include one or two transmission areas or may include four or more transmission areas. When the display panel 10 includes one transmission area, an opening corresponding to the one transmission area may be defined in the display panel 10 or may not be defined in the display panel 10. When the display panel 10 includes two transmission areas, the display panel 10 may include two openings corresponding to the two transmission areas. In an alternative embodiment, an opening corresponding to one of the two transmission areas may be defined in the display panel 10 and an opening for the remaining transmission area may not be defined in the display panel 10.

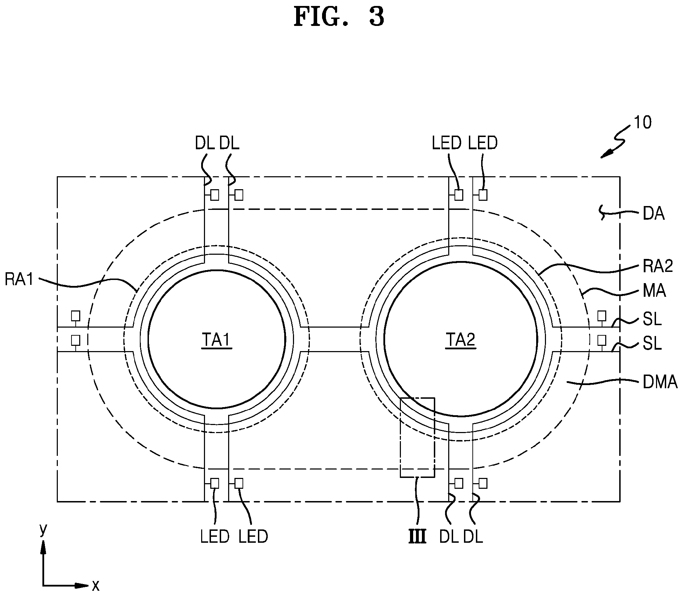

FIG. 3 is a plan view showing an embodiment of an excerpt of a portion of the display panel 10. For convenience of description, FIG. 3 illustrates that the display panel 10 includes two transmission areas, but as described above with reference to FIGS. 1A to 1C, the number of transmission areas may be changed.

Referring to FIG. 3, the display panel 10 may include the first transmission area TA1 and the second transmission area TA2, which are spaced apart from each other, the intermediate area MA surrounding the first transmission area TA1 and the second transmission area TA2, and the display area DA surrounding the intermediate area MA.

As described above with reference to FIG. 2, the first transmission area TA1 and the second transmission area TA2 are areas through which wavelengths, such as light, may penetrate, and may be a type of non-display area where a light-emitting diode for displaying an image is not disposed.

The intermediate area MA is a type of non-display area that does not emit light, and may surround the first transmission area TA1 and the second transmission area TA2. The intermediate area MA may include a routing area and a dummy area DMA around the routing area. A detouring portion of a signal line, e.g., a detouring portion of a data line DL and a detouring portion of a scan line SL, may pass in the routing area.

In this regard, FIG. 3 illustrates a first routing area RA1 surrounding the first transmission area TA1 and a second routing area RA2 surrounding the second transmission area TA2. The first routing area RA1 and the second routing area RA2 may have closed loop shapes respectively surrounding the first transmission area TA1 and the second transmission area TA2. The first routing area RA1 and the second routing area RA2 may be spaced apart from each other, and the dummy area DMA may surround the first routing area RA1 and the second routing area RA2.

Light-emitting diodes LED emitting red, green, and blue lights may be arranged in the display area DA. The red light emitted from the light-emitting diode LED emitting red light, the green light emitted from the light-emitting diode LED emitting green light, and the blue light emitted from the light-emitting diode LED emitting blue light may respectively correspond to a light emitted from a red sub-pixel, a light emitted from a green sub-pixel, and a light emitted from a blue sub-pixel of the display panel 10. However, the disclosure is not limited thereto, and light-emitting diode LED may emit various other colors.

Signal lines for providing a scan signal and a data signal to a transistor electrically connected to each light-emitting diode LED arranged in the display area DA, e.g., the scan line SL and the data line DL, may pass through the display area DA while detouring a transmission area in the intermediate area MA. In an embodiment, the scan line SL and the data line DL may detour a transmission area by being extended along an edge of a transmission area in a routing area (e.g., the first routing area RA1 or the second routing area RA2), for example.

In an embodiment, a scan line SL may extend in an x direction while detouring the first transmission area TA1 at an upper side of the first transmission area TA1 and detouring the second transmission area TA2 at an upper side of the second transmission area TA2, for example. Another scan line SL may extend in the x direction while detouring the first transmission area TA1 at a lower side of the first transmission area TA1 and detouring the second transmission area TA2 at a lower side of the second transmission area TA2. A data line DL may extend in a y direction while detouring the first transmission area TA1 at a left side of the first transmission area TA1, and another data line DL may extend in the y direction while detouring the first transmission area TA1 at a right side of the first transmission area TA1. Also, another data line DL may extend in the y direction while detouring the second transmission area TA2 at a left side of the second transmission area TA2, and another data line DL may extend in the y direction while detouring the second transmission area TA2 at a right side of the second transmission area TA2.

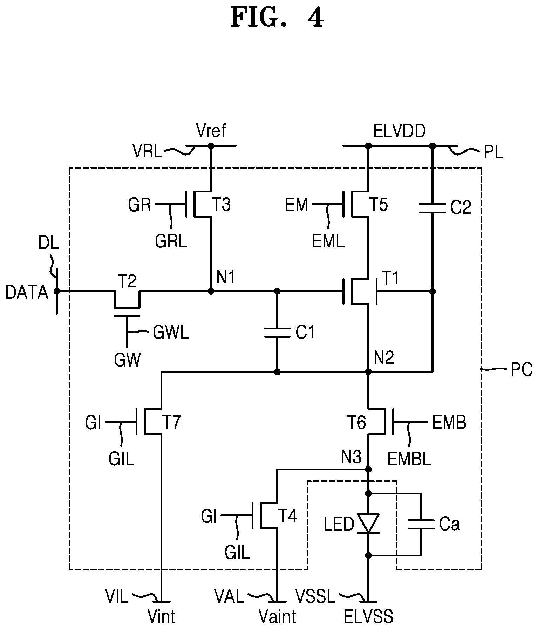

FIG. 4 is an equivalent circuit diagram schematically showing an embodiment of the light-emitting diode LED disposed in a display area and a driving circuit PC electrically connected to the light-emitting diode LED.

The driving circuit PC may be electrically connected to a first gate line GWL which transmits a first gate signal GW, a second gate line GIL which transmits a second gate signal GI, a third gate line GRL which transmits a third gate signal GR, a fourth gate line EML which transmits a fourth gate signal EM, a fifth gate line EMBL which transmits a fifth gate signal EMB, and the data line DL which transmits a data signal DATA. Light emission of the light-emitting diode LED is controlled by the fourth gate signal EM and the fifth gate signal EMB, and thus, the fourth gate signal EM and the fifth gate signal EMB may be also referred to as emission control signals, and the fourth gate line EML and the fifth gate line EMBL may be also referred to as emission control lines. The driving circuit PC may be electrically connected to a driving voltage line PL which transmits a driving voltage ELVDD, a reference voltage line VRL which transmits a reference voltage Vref, a first initialization voltage line VAL which transmits a first initialization voltage Vaint, and a second initialization voltage line VIL which transmits a second initialization voltage Vint.

In an embodiment, a plurality of transistors included in the driving circuit PC may be an N-type oxide thin-film transistor. An oxide thin-film transistor may be a low temperature polycrystalline oxide ("LTPO") thin-film transistor, in which a semiconductor layer includes an oxide. However, this is only an example, and the transistors of the disclosure are not limited thereto. In an embodiment, the semiconductor layer included in the N-type transistor may include an inorganic semiconductor (e.g., amorphous silicon or polysilicon) or an organic semiconductor, for example.

The driving circuit PC may include first to seventh transistors T1 to T7, first and second capacitors C1 and C2, and an auxiliary capacitor Ca. The first transistor T1 may be a driving transistor which outputs a driving current corresponding to the data signal DATA, and the second to seventh transistors T2 to T7 may be switching transistors which transmit signals. A first terminal (or a first electrode) and a second terminal (or a second electrode) of each of the first to seventh transistors T1 to T7 may be a source (or a source electrode) or a drain (or a drain electrode) depending on voltages of the first terminal and the second terminal. In an embodiment, according to the voltages of the first terminal and the second terminal, the first terminal may be a drain and the second terminal may be a source, or the first terminal may be a source and the second terminal may be a drain, for example. Hereinafter, a node to which a 1-1 gate of the first transistor T1 is connected may be defined as a first node N1, and a node to which the second terminal of the first transistor T1 is connected may be defined as a second node N2.

The first transistor T1 may be connected to the driving voltage line PL and the light-emitting diode LED. The first transistor T1 may be connected between the fifth transistor T5 and the sixth transistor T6. The first transistor T1 may include a gate (or a gate electrode), the first terminal, and the second terminal connected to the second node N2. The first transistor T1 may include the 1-1 gate connected to the first node N1. The first transistor T1 may further include a 1-2 gate connected to the second terminal of the first transistor T1. The 1-1 gate and the 1-2 gate may be arranged in different layers from each other while facing each other. In an embodiment, the 1-1 gate and the 1-2 gate of the first transistor T1 may face each other with a semiconductor layer therebetween, for example. Hereinafter, the gate (or the gate electrode) of the first transistor T1 may denote the 1-1 gate that is involved in turning the first transistor T1 on or off.

The 1-1 gate of the first transistor T1 may be connected to the second terminal of the second transistor T2, the first terminal of the third transistor T3, and a first capacitor C1. The 1-2 gate of the first transistor T1 may be connected to the first terminal of the sixth transistor T6, the first capacitor C1, and a second capacitor C2. The first terminal of the first transistor T1 may be connected to the driving voltage line PL via the fifth transistor T5, and the second terminal of the first transistor T1 may be connected to a pixel electrode of the light-emitting diode LED via the sixth transistor T6. The first terminal of the first transistor T1 may be connected to the second terminal of the fifth transistor T5. The second terminal of the first transistor T1 may be connected to the first terminal of the sixth transistor T6, the first capacitor C1, and the second capacitor C2. The first transistor T1 may control a current amount of the driving current flowing through the light-emitting diode LED by receiving the data signal DATA according to a switching operation of the second transistor T2.

The second transistor T2 may be connected to the data line DL and the 1-1 gate of the first transistor T1. The second transistor T2 may include a gate connected to the first gate line GWL, the first terminal connected to the data line DL, and the second terminal connected to the first node N1. The second terminal of the second transistor T2 may be connected to the 1-1 gate of the first transistor T1, the first terminal of the third transistor T3, and the first capacitor C1. The second transistor T2 is turned on by the first gate signal GW transmitted to the first gate line GWL to electrically connect the data line DL and the first node N1 to each other, and may transmit the data signal DATA transmitted to the data line DL to the first node N1.

The third transistor T3 may be connected to the 1-1 gate of the first transistor T1 and the reference voltage line VRL. The third transistor T3 may include a gate connected to the third gate line GRL, the first terminal connected to the first node N1, and the second terminal connected to the reference voltage line VRL. The first terminal of the third transistor T3 may be connected to the 1-1 gate of the first transistor T1, the second terminal of the second transistor T2, and the first capacitor C1. The third transistor T3 may be turned on by the third gate signal GR transmitted to the third gate line GRL to transmit the reference voltage Vref transmitted to the reference voltage line VRL to the first node N1.

The fourth transistor (also referred to as an initialization transistor) T4 may be connected to the sixth transistor T6 and the first initialization voltage line VAL. The fourth transistor T4 may be connected between the light-emitting diode LED and the first initialization voltage line VAL. The fourth transistor T4 may include a gate connected to the second gate line GIL, the first terminal connected to a third node N3, and the second terminal connected to the first initialization voltage line VAL. The first terminal of the fourth transistor T4 may be connected to the second terminal of the sixth transistor T6 and the pixel electrode of the light-emitting diode LED. The fourth transistor T4 may be turned on by the second gate signal GI transmitted to the second gate line GIL to transmit the first initialization voltage Vaint transmitted to the first initialization voltage line VAL to the third node N3, and initialize the pixel electrode (e.g., an anode) of the light-emitting diode LED.

The fifth transistor T5 may be connected to the driving voltage line PL and the first terminal of the first transistor T1. The fifth transistor T5 may include a gate connected to the fourth gate line EML, the first terminal connected to the driving voltage line PL, and the second terminal connected to the first terminal of the first transistor T1. The fifth transistor T5 may be turned on or off according to the fourth gate signal EM transmitted to the fourth gate line EML.

The sixth transistor T6 may be connected to the first transistor T1 and the light-emitting diode LED. The sixth transistor T6 may be connected between the second node N2 and the third node N3. The sixth transistor T6 may include a gate connected to the fifth gate line EMBL, the first terminal connected to the second node N2, and the second terminal connected to the third node N3. The first terminal of the sixth transistor T6 may be connected to the second terminal of the first transistor T1, the first capacitor C1, and the second capacitor C2. The second terminal of the sixth transistor T6 may be connected to the first terminal of the fourth transistor T4 and the pixel electrode of the light-emitting diode LED. The sixth transistor T6 may be turned on or off according to the fifth gate signal EMB transmitted to the fifth gate line EMBL.

The seventh transistor T7 may be connected between the first transistor T1 and the second initialization voltage line VIL. The seventh transistor T7 may include a gate connected to the second gate line GIL, the first terminal connected to the second node N2, and the second terminal connected to the second initialization voltage line VIL. The first terminal of the seventh transistor T7 may be connected to the second terminal of the first transistor T1, the first terminal of the sixth transistor T6, the first capacitor C1, and the second capacitor C2. The seventh transistor T7 may be turned on by the second gate signal GI transmitted to the second gate line GIL to transmit the second initialization voltage Vint transmitted to the second initialization voltage line VIL to the second node N2.

The first capacitor C1 may be connected between the 1-1 gate of the first transistor T1 and the second terminal of the first transistor T1. A first electrode of the first capacitor C1 may be connected to the first node N1 and a second electrode of the first capacitor C1 may be connected to the second node N2. The first electrode of the first capacitor C1 may be connected to the 1-1 gate of the first transistor T1, the second terminal of the second transistor T2, and the first terminal of the third transistor T3. The second electrode of the first capacitor C1 may be connected to the second terminal and 1-2 gate of the first transistor T1, the second electrode of the second capacitor C2, and the first terminal of the sixth transistor T6. The first capacitor C1 may store a voltage corresponding to the data signal DATA and a threshold voltage of the first transistor T1, as a storage capacitor.

The first transistor T1 may be turned on when the third transistor T3 and the fifth transistor T5 are turned on. When a voltage of the second terminal of the first transistor T1 is decreased to a difference Vref-Vth1 between the reference voltage Vref and a threshold voltage Vth1 of the first transistor T1, the first transistor T1 is turned off, and a voltage corresponding to the threshold voltage Vth1 of the first transistor T1 is stored in the first capacitor C1, and thus, the threshold voltage Vth1 of the first transistor T1 may be compensated for.

The second capacitor C2 may be connected between the driving voltage line PL and the second node N2. A first electrode of the second capacitor C2 may be connected to the driving voltage line PL. A second electrode of the second capacitor C2 may be connected to the second terminal and 1-2 gate of the first transistor T1, the second electrode of the first capacitor C1, and the first terminal of the sixth transistor T6.

Capacitance of each of the first capacitor C1 and the second capacitor C2 may vary according to a color of light emitted from the light-emitting diode LED.

The auxiliary capacitor Ca may be electrically connected to the sixth transistor T6, a retention voltage line VSSL and the pixel electrode of the light-emitting diode LED. The auxiliary capacitor Ca may prevent an issue in which black luminance is increased when the sixth transistor T6 is turned off, by storing and retaining a voltage corresponding to a voltage difference between the pixel electrode of the light-emitting diode LED and the retention voltage line VSSL.

The light-emitting diode LED may be connected to the first transistor T1 through the sixth transistor T6. The light-emitting diode LED may include the pixel electrode (anode) connected to the third node N3 and an opposing electrode (cathode) facing the pixel electrode, and the opposing electrode may receive a common voltage ELVSS. In an embodiment, the opposing electrode (cathode) may extend to the display area to be electrically connected to the retention voltage line VSSL which provides the common voltage ELVSS. The driving current output by the first transistor T1 flows through the light-emitting diode LED by the turned-on fifth transistor T5 and the turned-on sixth transistor T6, and the light-emitting diode LED may emit light of luminance corresponding to magnitude of the driving current.

FIG. 4 illustrates that the driving circuit PC includes seven transistors, but the disclosure is not limited thereto. In another embodiment, the driving circuit PC may include six or fewer transistors or eight or more transistors. Further, the driving circuit PC may include two or fewer capacitors or four or more capacitors.

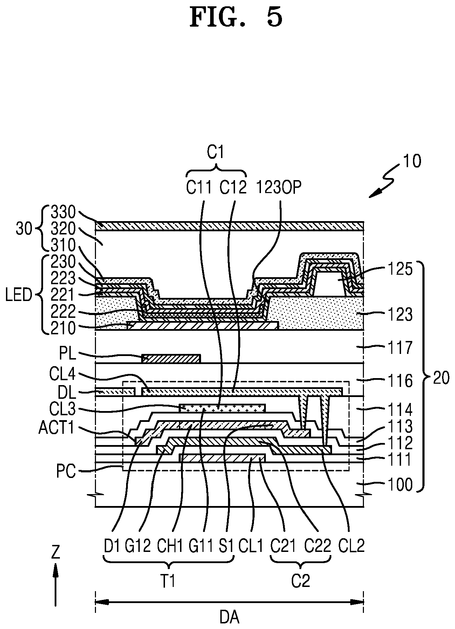

FIG. 5 is a cross-sectional view showing a portion of the display panel 10. For convenience of description, FIG. 5 illustrates the display layer 20 and the encapsulation layer 30 of the display panel 10, but as described with reference to FIG. 2, an input detection layer, an optical functional layer, and a cover window may be further included on the encapsulation layer 30.

Referring to FIG. 5, the display panel 10 may include the light-emitting diode LED disposed in the display area DA. The light-emitting diode LED is disposed on a substrate 100, and the driving circuit PC may be disposed between the light-emitting diodes LED on the substrate 100. In this regard, FIG. 5 illustrates the first transistor T1, the first capacitor C1, and the second capacitor C2 as some components of the driving circuit PC.

The substrate 100 may include a glass material or a polymer resin. In an embodiment, the substrate 100 may have an alternating stack structure of a base layer including a polymer resin and a barrier layer including an inorganic insulating material, such as silicon oxide or silicon nitride. The polymer resin may include a polymer resin such as polyether sulfone, polyacrylate, polyether imide, polyethylene naphthalate, polyethylene terephthalate, polyphenylene sulfide, polyimide, polycarbonate, cellulose triacetate, or cellulose acetate propionate.

A first conductive layer CL1 may be disposed on the substrate 100. The first conductive layer CL1 may include a conductive material such as a metal. In an embodiment, the first conductive layer CL1 may include a conductive material including molybdenum (Mo), aluminum (Al), copper (Cu), and/or titanium (Ti), and may have a single layer or multilayer structure including the conductive material, for example.

A buffer layer 111 may be disposed on the first conductive layer CL1. The buffer layer 111 may include an inorganic insulating material, such as a silicon oxide, a silicon nitride, and/or a silicon oxynitride, and may have a single layer or multiplayer structure including the inorganic insulating material.

A second conductive layer CL2 is disposed on the buffer layer 111 and may overlap the first conductive layer CL1. In an embodiment, the first conductive layer CL1 may include a first electrode C21 of the second capacitor C2, and the second conductive layer CL2 may include a second electrode C22 of the second capacitor C2. The second conductive layer CL2 may include a conductive material including molybdenum (Mo), aluminum (Al), copper (Cu), and/or titanium (Ti), and may have a single layer or multilayer structure including the conductive material.

The first insulating layer 112 may be disposed on the second conductive layer CL2. The first insulating layer 112 may include an inorganic insulating material, such as a silicon oxide, a silicon nitride, and/or a silicon oxynitride, and may have a single layer or multiplayer structure including the inorganic insulating material.

A semiconductor layer ACT1 may be disposed on the first insulating layer 112. The semiconductor layer ACT1 may include a channel region CH1, and a source region S1 and a drain region D1 arranged on opposite sides of the channel region CH1 respectively. The semiconductor layer ACT1 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). In an embodiment, the semiconductor layer ACT1 may include an InSnZnO ("ITZO") semiconductor layer or an InGaZnO ("IGZO") semiconductor layer, for example. A conducting process according to a plasma process may be performed on at least a portion of the semiconductor layer ACT1.

A third conductive layer CL3 may be disposed on the semiconductor layer ACT1 with a second insulating layer 113 therebetween. A portion of the third conductive layer CL3 may include a 1-1 gate electrode G11 overlapping the channel region CH1, and a portion of the second conductive layer CL2 may include a 1-2 gate electrode G12 overlapping the channel region CH1. The 1-1 gate electrode G11 and the 1-2 gate electrode G12 may overlap each other with the channel region CH1 therebetween. The second insulating layer 113 may include an inorganic insulating material, such as a silicon oxide, a silicon nitride, or a silicon oxynitride, and may have a single layer or multiplayer structure including the inorganic insulating material.

A third insulating layer 114 may be disposed on the third conductive layer CL3. The third insulating layer 114 may include an inorganic insulating material, such as a silicon oxide, a silicon nitride, or a silicon oxynitride, and may have a single layer or multiplayer structure including the inorganic insulating material.

The third conductive layer CL3 may include a first electrode C11 of the first capacitor C1, and a fourth conductive layer CL4 on the third insulating layer 114 may include a second electrode C12 of the first capacitor C1. The third conductive layer CL3 and the fourth conductive layer CL4 may each include a conductive material including molybdenum (Mo), aluminum (Al), copper (Cu), or titanium (Ti), and may have a single layer or multilayer structure including the conductive material.

The data line DL may be disposed on the third insulating layer 114. The data line DL may include a conductive material including molybdenum (Mo), aluminum (Al), copper (Cu), or titanium (Ti), and may have a single layer or multilayer structure including the conductive material.

A fourth insulating layer 116 may be disposed on the data line DL. The fourth insulating layer 116 may include an organic insulating material such as acryl, benzo cyclobutene ("BCB"), polyimide, or hexamethyldisiloxane ("HMDSO").

In FIG. 5, the fourth conductive layer CL4 and the data line DL are arranged in a same layer, but the disclosure is not limited thereto. In another embodiment, an insulating layer may be further disposed between the fourth conductive layer CL4 and the data line DL, and the data line DL may be disposed on the additional insulating layer and the fourth conductive layer CL4 may be disposed below the additional insulating layer.

The driving voltage line PL may be disposed on the fourth insulating layer 116 and covered by a fifth insulating layer 117. The driving voltage line PL may include a conductive material including molybdenum (Mo), aluminum (Al), copper (Cu), or titanium (Ti), and may have a single layer or multilayer structure including the conductive material. The fifth insulating layer 117 may include an organic insulating material.

Although not illustrated in FIG. 5, other voltage lines, e.g., the retention voltage line VSSL of FIG. 4, the first and second initialization voltage lines VAL and VIL of FIG. 4, and the reference voltage line VRL of FIG. 4, may be arranged in a same layer as the driving voltage line PL on the fourth insulating layer 116, for example.

The light-emitting diode LED may include a pixel electrode 210, an emission layer 222, and an opposing electrode 230.

The pixel electrode 210 may be disposed on the fifth insulating layer 117. The pixel electrode 210 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any combinations thereof. In another embodiment, the pixel electrode 210 may further include a conductive oxide layer on and/or below the reflective layer. The conductive oxide layer may include indium tin oxide ("ITO"), indium zinc oxide ("IZO"), zinc oxide (ZnO), indium oxide (In2O3), indium gallium oxide ("IGO"), and/or aluminum zinc oxide ("AZO"). In an embodiment, the pixel electrode 210 may have a three-layer structure of ITO layer/Ag layer/ITO layer.

A bank layer 123 may be disposed on the pixel electrode 210. An opening 123OP overlapping the pixel electrode 210 may be defined in the bank layer 123, and the bank layer 123 may cover an edge of the pixel electrode 210. The bank layer 123 may include an organic insulating material. In an embodiment, the bank layer 123 may include an organic insulating material including a light-shielding material, for example. In some embodiments, the bank layer 123 may include a polyimide ("PI")-based binder and a pigment in which red, green, and blue are mixed. In an alternative embodiment, the bank layer 123 may include a cardo-based binder resin and a combination of a lactam black pigment and a blue pigment. In an alternative embodiment, the bank layer 123 may include carbon black. The bank layer 123 may enhance contrast of the display panel 10.

A spacer 125 may be disposed on the bank layer 123. The spacer 125 may include a material different from that of the bank layer 123. In an embodiment, the bank layer 123 and the spacer 125 may include different materials from each other, e.g., the bank layer 123 may include a negative photosensitive material whereas the spacer 125 may include a positive photosensitive material, and may be formed through individual mask processes. In another embodiment, the spacer 125 may include a same material as a material of the bank layer 123 and may be formed together with the bank layer 123 through a same mask process (e.g., a halftone mask process).

The emission layer 222 may include a high-molecular weight organic material or low-molecular weight organic material, which emit light of a predetermined color. The emission layer 222 may include a material emitting a red light, a green light, or a blue light, according to the light-emitting diode LED.

A functional layer may be further provided below and/or on the emission layer 222. In an embodiment, a first functional layer 221 may be further provided between the pixel electrode 210 and the emission layer 222, and a second functional layer 223 may be further provided between the emission layer 222 and the opposing electrode 230 described below, for example. The first functional layer 221 may include a hole transport layer and/or a hole injection layer. The second functional layer 223 may include an electron transport layer and/or an electron injection layer.

The opposing electrode 230 may include a conductive material with a relatively low work function. In an embodiment, the opposing electrode 230 may include a (semi-)transparent layer including Ag, Mg, Al, Pt, Pd, Au, Ni, Nd, Ir, Cr, Li, Ca, or any alloys thereof, for example. The opposing electrode 230 may further include a layer including ITO, IZO, ZnO, and/or In2O3, on the (semi-)transparent layer including such a material.

Unlike the pixel electrode 210 being individually formed to correspond to the light-emitting diode LED, the opposing electrode 230 may extend to correspond to the pixel electrodes 210. In an embodiment, the pixel electrode 210 of one light-emitting diode LED and the pixel electrode 210 of another light-emitting diode LED may be separated and spaced apart from each other, but the opposing electrode 230 overlapping the pixel electrodes 210 may extend to cover the pixel electrodes 210, for example.

The encapsulation layer 30 may be disposed on the display layer 20 and include at least one inorganic encapsulation layer and at least one organic encapsulation layer. In an embodiment, FIG. 5 illustrates that the encapsulation layer 30 includes a first inorganic encapsulation layer 310, an organic encapsulation layer 320, and a second inorganic encapsulation layer 330.

The first inorganic encapsulation layer 310 and the second inorganic encapsulation layer 330 may include at least one inorganic encapsulation layer selected from among aluminum oxide, titanium oxide, tantalum oxide, hafnium oxide, zinc oxide, silicon oxide, silicon nitride, and silicon oxynitride. The first inorganic encapsulation layer 310 and the second inorganic encapsulation layer 330 may be a single layer or multilayer including the above material. The organic encapsulation layer 320 may include a polymer-based material. In embodiments, the polymer-based material may include an acrylic resin, an epoxy resin, polyimide, and polyethylene. In an embodiment, the organic encapsulation layer 320 may include acrylate.

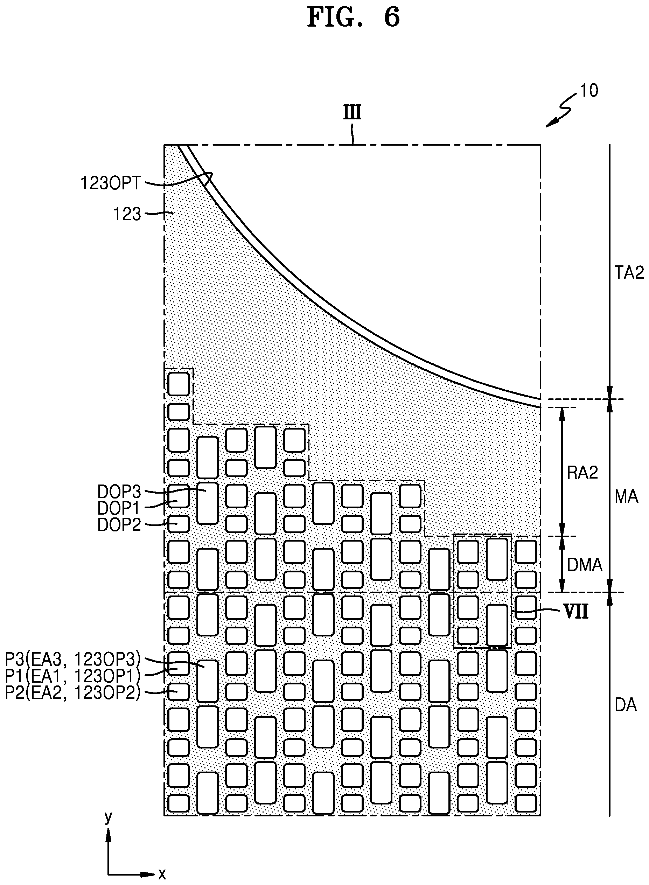

FIG. 6 is a plan view showing an embodiment of a portion of the display panel 10, and illustrates a region III of FIG. 3.

Referring to the display area DA of FIG. 6, pixels emitting different lights, e.g., first to third pixels P1 to P3, may be arranged in the display area DA. In an embodiment, the first pixel P1 and the second pixel P2 may be arranged in a same column, and a third pixel P3 may be disposed in a column adjacent to the column where the first pixel P1 and the second pixel P2 are arranged, for example.

One of the first to third pixels P1 to P3 may be a red pixel, another one may be a green pixel, and a remaining one may be a blue pixel. The first to third pixels P1 to P3 may correspond to emission areas in which lights are emitted from corresponding light-emitting diodes. In an embodiment, the first pixel P1 may correspond to an emission area (hereinafter, a first emission area EA1) of a light-emitting diode corresponding to the first pixel P1, the second pixel P2 may correspond to an emission area (hereinafter a second emission area EA2) of a light-emitting diode corresponding to the second pixel P2, and the third pixel P3 may correspond to an emission area (hereinafter, a third emission area EA3) of a light-emitting diode corresponding to the third pixel P3, for example.

The emission area may be defined as an opening of the bank layer 123 of FIG. 5 described above with reference to FIG. 5, e.g., the opening 123OP of FIG. 5 overlapping the pixel electrode 210 of FIG. 5. Accordingly, the first to third emission areas EA1 to EA3 of FIG. 6 may respectively correspond to first to third openings 123OP1 to 123OP3 of the bank layer 123.

Referring to the intermediate area MA of FIG. 6, the bank layer 123 may extend towards the intermediate area MA, and dummy openings may be defined in the bank layer 123 in the intermediate area MA with a predetermined pattern. In this regard, FIG. 6 illustrates first to third dummy openings DOP1 to DOP3 defined in the intermediate area MA, e.g., the dummy area DMA. In some embodiments, dummy openings may not be defined in a routing area, e.g., the second routing area RA2 as shown in FIG. 6.

An arrangement of the first to third dummy openings DOP1 to DOP3 may be substantially the same as an arrangement of the first to third openings 123OP1 to 123OP3. The first dummy opening DOP1 and the second dummy opening DOP2 may be defined in a same column, and the third dummy opening DOP3 may be defined in a column adjacent to the column of the first dummy opening DOP1 and the second dummy opening DOP2. The first dummy opening DOP1 and the second dummy opening DOP2, and the first opening 123OP1 and the second opening 123OP2 may be defined in a same column, and the third dummy opening DOP3 and the third opening 123OP3 may be defined in a same column. An interval between the first and second dummy openings DOP1 and DOP2, and an interval between the first and second openings 123OP1 and 123OP2 may be substantially the same as each other.

Sizes of the first to third dummy openings DOP1 to DOP3 and sizes of the first to third openings 123OP1 to 123OP3 may be substantially the same, respectively. In an embodiment, a width of the first dummy opening DOP1 in the x direction and a length of the first dummy opening DOP1 in the y direction may be substantially the same as a width of the first opening 123OP1 in the x direction and a length of the first opening 123OP1 in the y direction, for example. A width of the second dummy opening DOP2 in the x direction and a length of the second dummy opening DOP2 in the y direction may be substantially the same as a width of the second opening 123OP2 in the x direction and a length of the second opening 123OP2 in the y direction. A width of the third dummy opening DOP3 in the x direction and a length of the third dummy opening DOP3 in the y direction may be substantially the same as a width of the third opening 123OP3 in the x direction and a length of the third opening 123OP3 in the y direction.

The bank layer 123 defines dummy openings, e.g., the first to third dummy openings DOP1 to DOP3, and thus, reflectance in the intermediate area MA and reflectance in the display area DA of the display panel 10 may be similar to each other. In detail, the first to third dummy openings DOP1 to DOP3 of the bank layer 123 defined in the intermediate area MA have substantially the same arrangements and/or sizes as arrangements and/or sizes of the first to third openings 123OP1 to 123OP3 as described above, and thus, the display area DA and the intermediate area MA may be effectively prevented from being differently recognized by a user in an off state (when not operating) of the display panel 10.

Referring to a transmission area, e.g., the second transmission area TA2, of FIG. 6, an opening (hereinafter, a transmission opening 123OPT) overlapping the transmission area, e.g., the second transmission area TA2, may be defined in the bank layer 123. A size of the transmission opening 123OPT may be substantially the same as or greater than a size of the second transmission area TA2.

FIG. 6 illustrates the intermediate area MA and the display area DA around the second transmission area TA2, but the disclosure is not limited thereto. In another embodiment, a structure around another transmission area, such as the first transmission area TA1, may be the same as a structure shown in FIG. 6.

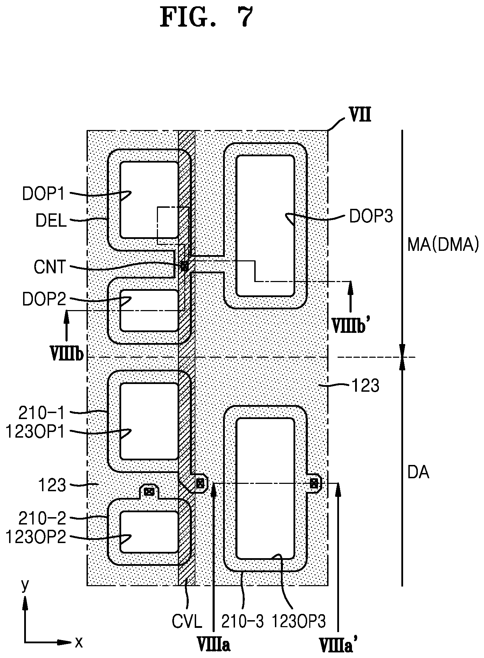

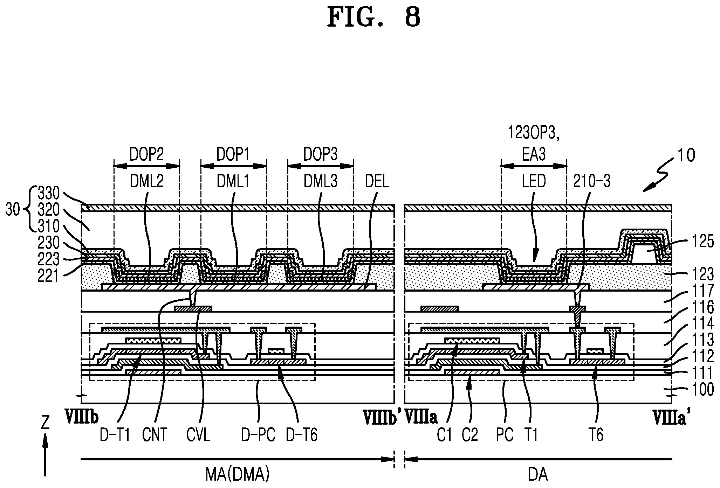

FIG. 7 is a plan view showing an embodiment of an excerpt of a region VII shown in FIG. 6, as the display panel 10, and FIG. 8 is a cross-sectional view of the display panel 10 taken along lines VIIIa-VIIIa' and VIIIb-VIIIb' of FIG. 7.

Referring to the display area DA of FIG. 7, a first pixel electrode 210-1, a second pixel electrode 210-2, and a third pixel electrode 210-3 may be arranged in the display area DA while being spaced apart from each other. The first pixel electrode 210-1 and the second pixel electrode 210-2 may be arranged in a same column, and the third pixel electrode 210-3 may be disposed in a column adjacent to the column where the first pixel electrode 210-1 and the second pixel electrode 210-2 are arranged.

Referring to the display area DA of FIG. 7 and the cross-sectional view taken along line VIIIa-VIIIa' of FIG. 8, the bank layer 123 may cover edges of the first pixel electrode 210-1, the second pixel electrode 210-2, and the third pixel electrode 210-3, and define the first opening 123OP1 overlapping the first pixel electrode 210-1, the second opening 123OP2 overlapping the second pixel electrode 210-2, and the third opening 123OP3 overlapping the third pixel electrode 210-3.

A size (or an area) of an opening of the bank layer 123 may correspond to a size (or an area) of an area emitting light and/or a size (or an area) of a sub-pixel. In an embodiment, a size (or an area) of the first opening 123OP1 of the bank layer 123 may correspond to a size (or an area) of an emission area (i.e., the first emission area EA1 of FIG. 6) of light emitted to a light-emitting diode including the first pixel electrode 210-1 and/or a size (or an area) of the first pixel P1 of FIG. 6, for example. A size (or an area) of the second opening 123OP2 of the bank layer 123 may correspond to a size (or an area) of an emission area (i.e., the second emission area EA2 of FIG. 6) of light emitted to a light-emitting diode including the second pixel electrode 210-2 and/or a size (or an area) of the second pixel P2 of FIG. 6. A size (or an area) of the third opening 123OP3 of the bank layer 123 may correspond to a size (or an area) of an emission area (i.e., the third emission area EA3 of FIG. 6) of light emitted to a light-emitting diode including the third pixel electrode 210-3 and/or a size (or an area) of the third pixel P3 of FIG. 6.

The first to third pixel electrodes 210-1 to 210-3 and the first to third openings 123OP1 to 123OP3 of the bank layer 123 may each overlap a transistor. In this regard, FIG. 8 illustrates the first and second capacitors C1 and C2, the first transistor T1, and the sixth transistor T6 of the driving circuit PC, and that the third pixel electrode 210-3 and the third opening 123OP3 of the bank layer 123 overlap the first transistor T1 and/or the sixth transistor T6 of the driving circuit PC.

A detailed structure of the light-emitting diode LED of FIG. 8 including the third pixel electrode 210-3 is the same as that described above with reference to FIG. 5, and the light-emitting diode LED may be encapsulated by the encapsulation layer 30. Detailed structures of light-emitting diodes including the first and second pixel electrodes 210-1 and 210-2 are also as described above with reference to FIG. 5, except that a material of an emission layer overlapping each of the first to third pixel electrodes 210-1 to 210-3 through the first to third openings 123OP1 to 123OP3 is different.

Referring to the intermediate area MA of FIG. 7, a dummy electrode layer DEL may be disposed in the intermediate area MA. The dummy electrode layer DEL may include a first portion having a shape corresponding to the first pixel electrode 210-1, a second portion having a shape corresponding to the second pixel electrode 210-2, and a third portion having a shape corresponding to the third pixel electrode 210-3, and the first to third portions may be integrally connected to each other.

The bank layer 123 may define the first to third dummy openings DOP1 to DOP3 overlapping the same dummy electrode layer DEL. The first dummy opening DOP1 may overlap the first portion of the dummy electrode layer DEL, the second dummy opening DOP2 may overlap the second portion of the dummy electrode layer DEL, and the third dummy opening DOP3 may overlap the third portion of the dummy electrode layer DEL.

The arrangement of the first to third dummy openings DOP1 to DOP3 may be substantially the same as the arrangement of the first to third openings 123OP1 to 123OP3. In an embodiment, the first dummy opening DOP1 and the second dummy opening DOP2 may be defined in a same column, and the third dummy opening DOP3 may be defined in a column adjacent to the column where the first dummy opening DOP1 and the second dummy opening DOP2 are defined, for example.

The first and second dummy openings DOP1 and DOP2, and the first and second openings 123OP1 and 123OP2 may be defined in a same column, and the third dummy opening DOP3 and the third opening 123OP3 may be defined in a same column. The sizes of the first to third dummy openings DOP1 to DOP3 and the sizes of the first to third openings 123OP1 to 123OP3 may be substantially the same, respectively. The interval between the first and second dummy openings DOP1 and DOP2, and the interval between the first and second openings 123OP1 and 123OP2 may be substantially the same as each other.

Referring to the intermediate area MA of FIG. 7 and the cross-sectional view taken along line VIIIb-VIIIb' of FIG. 8, the dummy electrode layer DEL may be disposed in a same layer as the first to third pixel electrodes 210-1 to 210-3 on the fifth insulating layer 117 as shown in FIG. 8, for example. The dummy electrode layer DEL may include a same material as a material of the first to third pixel electrodes 210-1 to 210-3.

The dummy electrode layer DEL may be electrically connected to a voltage line CVL through a contact hole CNT penetrating an insulating layer disposed between the dummy electrode layer DEL and the voltage line CVL, e.g., the fifth insulating layer 117. The voltage line CVL may be the retention voltage line VSSL described above with reference to FIG. 4 or the first initialization voltage line VAL. The voltage line CVL may extend towards the intermediate area MA in the display area DA, and the dummy electrode layer DEL may be electrically connected to the voltage line CVL disposed therebelow. In an embodiment, a location of the contact hole CNT may be within a virtual triangle connecting a center of the first dummy opening DOP1, a center of the second dummy opening DOP2, and a center of the third dummy opening DOP3, in a plan view as shown in FIG. 7.

The first to third dummy openings DOP1 to DOP3 and the dummy electrode layer DEL may overlap a dummy transistor therebelow, as shown in FIG. 8. When the driving circuit PC is formed in the display area DA, a dummy driving circuit D-PC may also be formed in the intermediate area MA, and in this regard, FIG. 8 illustrates the dummy driving circuit D-PC including a first dummy transistor D-T1 and a sixth dummy transistor D-T6. The dummy electrode layer DEL and the first to third dummy openings DOP1 to DOP3 may overlap a dummy transistor of the dummy driving circuit D-PC, e.g., the first dummy transistor D-T1 and/or the sixth dummy transistor D-T6. The dummy driving circuit D-PC is not electrically connected to the dummy electrode layer DEL. In other words, the dummy driving circuit D-PC is electrically insulated from the dummy electrode layer DEL.

As shown in FIG. 8, first to third dummy emission layers DML1 to DML3 overlap the first to third portions of the dummy electrode layer DEL through the first to third dummy openings DOP1 to DOP3 on the dummy electrode layer DEL, and the opposing electrode 230 may extend over the first to third dummy emission layers DML1 to DML3. Similarly, the first and second functional layers 221 and 223 may also extend over the first to third dummy emission layers DML1 to DML3. However, in an embodiment, when the voltage line CVL includes the retention voltage line VSSL of FIG. 4, the dummy electrode layer DEL has a same voltage level as a voltage level of the opposing electrode 230, and thus, a light is not emitted from a stack structure of the first to third portions of the dummy electrode layer DEL, the first to third dummy emission layers DML1 to DML3, and the opposing electrode 230. In another embodiment, when the voltage line CVL includes the first initialization voltage line VAL of FIG. 4, the dummy electrode layer DEL has a voltage level lower than a sum of the common voltage ELVSS of FIG. 4 and a threshold voltage Vth of a light-emitting diode, and thus, a light is not emitted from the stack structure of the first to third portions of the dummy electrode layer DEL, the first to third dummy emission layers DML1 to DML3, and the opposing electrode 230. In other words, the stack structure of the dummy electrode layer DEL, the first to third dummy emission layers DML1 to DML3, and the opposing electrode 230 corresponds to a type of a dummy emission structure.

In FIGS. 7 and 8, it is described that the dummy electrode layer DEL is electrically connected to the voltage line CVL, but the disclosure is not limited thereto. In another embodiment, the dummy electrode layer DEL may be in an electrically floating state without being electrically connected to the voltage line CVL. FIGS. 6 to 8 illustrate a portion of the intermediate area MA around the second transmission area TA2, which corresponds to the region III of FIG. 3, but the disclosure is not limited thereto. A structure of a portion of the intermediate area MA around the first transmission area TA1 may be substantially the same as the structure of the embodiment described with reference to FIGS. 6 to 8.

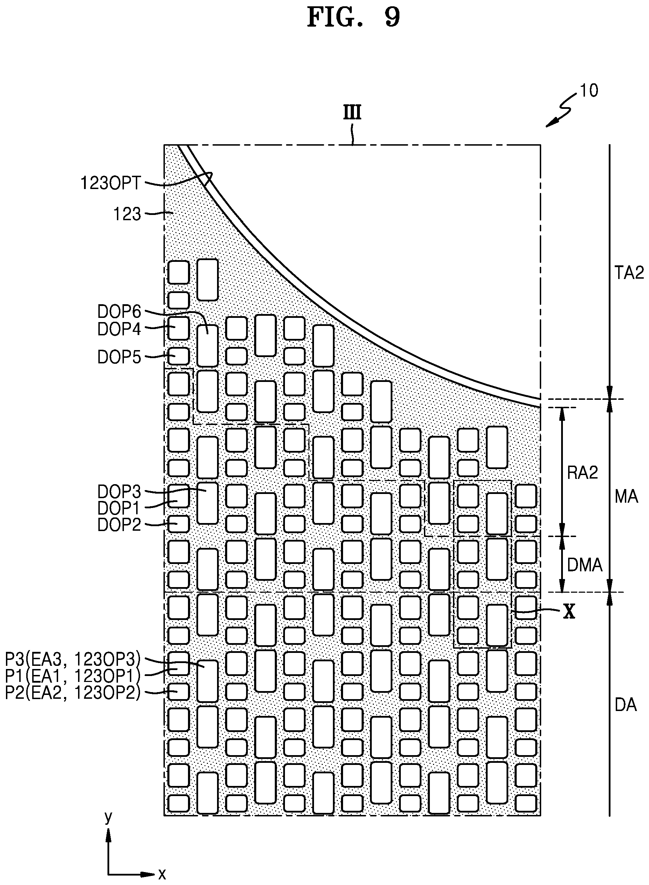

FIG. 9 is a plan view showing an embodiment of a portion of the display panel 10, in an embodiment, and illustrates the region III of FIG. 3.

The display panel 10 in an embodiment of FIG. 9 includes the structure described above with reference to FIG. 6. In an embodiment, as shown in FIG. 9, the display panel 10 may include pixels emitting different colors of lights, e.g., the first to third pixels P1 to P3, in the display area DA, and dummy openings e.g., the first to third dummy openings DOP1 to DOP3, may be defined in the display panel 10 in the dummy area DMA, for example. Also, the transmission opening 123OPT of the bank layer 123 overlapping a transmission area, e.g., the second transmission area TA2, may be defined in the display panel 10. As described above, the first to third pixels P1 to P3 are emission areas of lights emitted from light-emitting diodes and correspond to the first to third emission areas EA1 to EA3, and the first to third emission areas EA1 to EA3 correspond to the first to third openings 123OP1 to 123OP3 of the bank layer 123.

In an embodiment of FIG. 9, additional dummy openings defined in the routing area, e.g., the second routing area RA2 among the intermediate area MA, may be further provided. In this regard, FIG. 9 illustrates fourth to sixth dummy openings DOP4 to DOP6 of the bank layer 123.

An arrangement of the fourth to sixth dummy openings DOP4 to DOP6 may be substantially the same as an arrangement of the first to third dummy openings DOP1 to DOP3 and/or an arrangement of the first to third openings 123OP1 to 123OP3. The fourth and fifth dummy openings DOP4 and DOP5 may be defined in a same column, and the sixth dummy opening DOP6 may be defined in a column adjacent to the column where the fourth and fifth dummy openings DOP4 and DOP5 are defined. The fourth and fifth dummy openings DOP4 and DOP5, the first and second dummy openings DOP1 and DOP2, and the first and second openings 123OP1 and 123OP2 may be defined in a same column, and the sixth dummy opening DOP6, the third dummy opening DOP3, and the third opening 123OP3 may be defined in a same column. An interval between the fourth and fifth dummy openings DOP4 and DOP5, an interval between the first and second dummy openings DOP1 and DOP2, and an interval between the first and second openings 123OP1 and 123OP2 may be substantially the same as each other.

Sizes of the fourth to sixth dummy openings DOP4 to DOP6 may be substantially the same as sizes of the first to third dummy openings DOP1 to DOP3 and/or sizes of the first to third openings 123OP1 to 123OP3, respectively. In an embodiment, a width of the fourth dummy opening DOP4 in the x direction and a length of the fourth dummy opening DOP4 in the y direction may be substantially the same as a width of the first dummy opening DOP1 in the x direction and a length of the first dummy opening DOP1in the y direction and/or a width of the first opening 123OP1 in the x direction and a length of the first opening 123OP1 in the y direction, for example. A width of the fifth dummy opening DOP5 in the x direction and a length of the fifth dummy opening DOP5 in the y direction may be substantially the same as a width of the second dummy opening DOP2 in the x direction and a length of the second dummy opening DOP2 in the y direction and/or a width of the second opening 123OP2 in the x direction and a length of the second opening 123OP2 in the y direction. A width of the sixth dummy opening DOP6 in the x direction and a length of the sixth dummy opening DOP6 in the y direction may be substantially the same as a width of the third dummy opening DOP3 in the x direction and a length of the third dummy opening DOP3 in the y direction and/or a width of the third opening 123OP3 in the x direction and a length of the third opening 123OP3 in the y direction.

The bank layer 123 defines dummy openings, e.g., the first to third dummy openings DOP1 to DOP3 and the fourth to sixth dummy openings DOP4 to DOP6, and thus, reflectance in the intermediate area MA and reflectance in the display area DA of the display panel 10 may be similar to each other. In an embodiment, the first to third dummy openings DOP1 to DOP3 and the fourth to sixth dummy openings DOP4 to DOP6 of the bank layer 123 defined in the intermediate area MA have substantially the same arrangement and/or size as arrangements and/or sizes of the first to third openings 123OP1 to 123OP3 as described above, and thus, the display area DA and the intermediate area MA may be further effectively prevented from being differently recognized by the user in the off state (when not operating) of the display panel 10, for example.

FIG. 9 illustrates the intermediate area MA and the display area DA around the second transmission area TA2, but the disclosure is not limited thereto. In another embodiment, a structure around another transmission area, such as the first transmission area TA1, may be the same as a structure shown in FIG. 9.

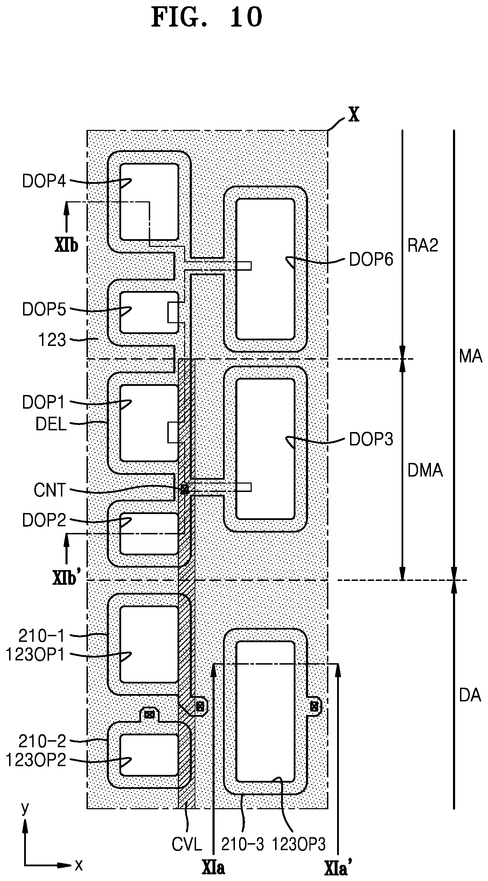

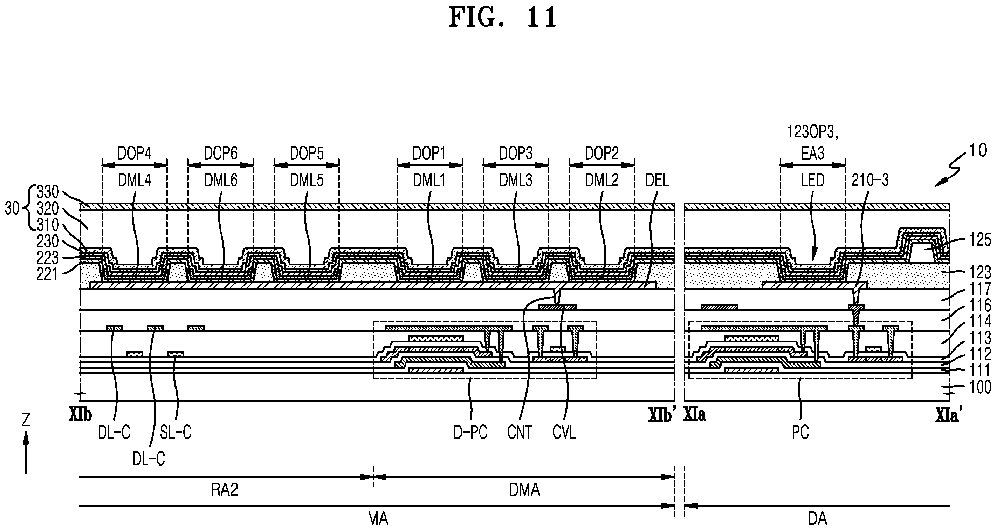

FIG. 10 is a plan view showing an embodiment of an excerpt of a region X of FIG. 9 as the display panel 10, and FIG. 11 is a cross-sectional view of the display panel taken along lines XIa-XIa' and XIb-XIb' of FIG. 10.

Structures of the display area DA and the dummy area DMA among the intermediate area MA of FIGS. 10 and 11 are the same as those described above with reference to FIGS. 7 and 8, and thus the explanation of the same constructions will be replaced by a description referring to FIGS. 7 and 8,.

Referring to the second routing area RA2 among the intermediate area MA of FIG. 10, the dummy electrode layer DEL disposed in the dummy area DMA may extend towards the second routing area RA2. In the second routing area RA2, the fourth to sixth dummy openings DOP4 to DOP6 that overlap the dummy electrode layer DEL may be defined in the bank layer 123 with a predetermined pattern.

The fourth dummy opening DOP4 may overlap a fourth portion of the dummy electrode layer DEL, the fifth dummy opening DOP5 may overlap a fifth portion of the dummy electrode layer DEL, and the sixth dummy opening DOP6 may overlap a sixth portion of the dummy electrode layer DEL. The first dummy opening DOP1 may overlap the first portion of the dummy electrode layer DEL, the second dummy opening DOP2 may overlap the second portion of the dummy electrode layer DEL, and the third dummy opening DOP3 may overlap the third portion of the dummy electrode layer DEL.

A portion of the dummy electrode layer DEL extending towards the routing area, e.g., the second routing area RA2, may have a substantially a same shape as a shape of a portion of the dummy electrode layer DEL disposed in the dummy area DMA in a plan view, and may be integrally connected thereto. In an embodiment, a relative arrangement between the fourth to sixth portions of the dummy electrode layer DEL arranged in the second routing area RA2 and a size of each portion (e.g., a width in the x direction and a length in the y direction) may be the same as a relative arrangement between the first to third portions of the dummy electrode layer DEL arranged in the dummy area DMA and a size of each portion (e.g., a width in the x direction and a length in the y direction), for example.

In the dummy area DMA, the dummy electrode layer DEL may overlap a dummy transistor of the dummy driving circuit D-PC therebelow, and may be electrically connected to the voltage line CVL extending towards the intermediate area MA. The voltage line CVL may be the retention voltage line VSSL described above with reference to FIG. 4 or the first initialization voltage line VAL. In the specification, when it is described that "A is disposed below B", A and B may be arranged and/or overlap each other in a direction perpendicular to the substrate 100 of FIG. 11, and an electrode, a component, and/or a layer may be provided between A and B.

A transistor is not disposed in the routing area, e.g., the second routing area RA2. Accordingly, in the second routing area RA2, the dummy electrode layer DEL does not overlap a transistor, for example a dummy transistor. Similarly, the fourth to sixth dummy openings DOP4 to DOP6 do not overlap a transistor.

In some embodiments, the dummy electrode layer DEL extending towards the second routing area RA2 and/or at least one selected from the fourth to sixth dummy openings DOP4 to DOP6 may overlap a detouring portion of a signal line disposed therebelow.

Referring to the cross-sectional view taken along line XIb-XIb' of FIG. 11, a portion of the dummy electrode layer DEL extending towards the second routing area RA2 and/or at least one selected from the fourth to sixth dummy openings DOP4 to DOP6 may overlap a detouring portion DL-C of a data line and/or a detouring portion SL-C of a scan line, which detour around the second transmission area TA2 of FIG. 9. The detouring portion DL-C of the data line and the detouring portion SL-C of the scan line may be arranged in different layers from each other with insulating layers therebetween. The detouring portion DL-C of the data line and/or the detouring portion SL-C of the scan line, described above, correspond to portions of the data line DL and the scan line SL, e.g., portions detouring around a transmission area, providing signals to drive the light-emitting diode LED of FIG. 3 disposed in the display area DA as described above with reference to FIG. 3. FIGS. 9 to 11 illustrate a portion of the intermediate area MA around the second transmission area TA2, which corresponds to the region III of FIG. 3, but the disclosure is not limited thereto. The structure of the portion of the intermediate area MA around the first transmission area TA1 may be substantially the same as the structure of the embodiment described with reference to FIGS. 9 to 11.

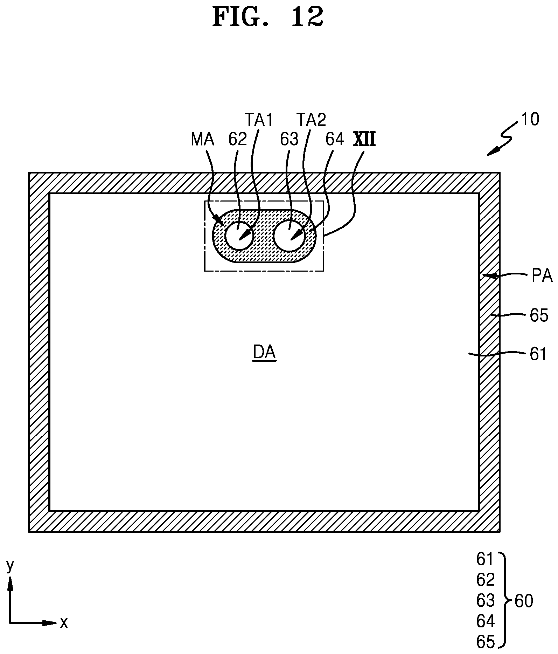

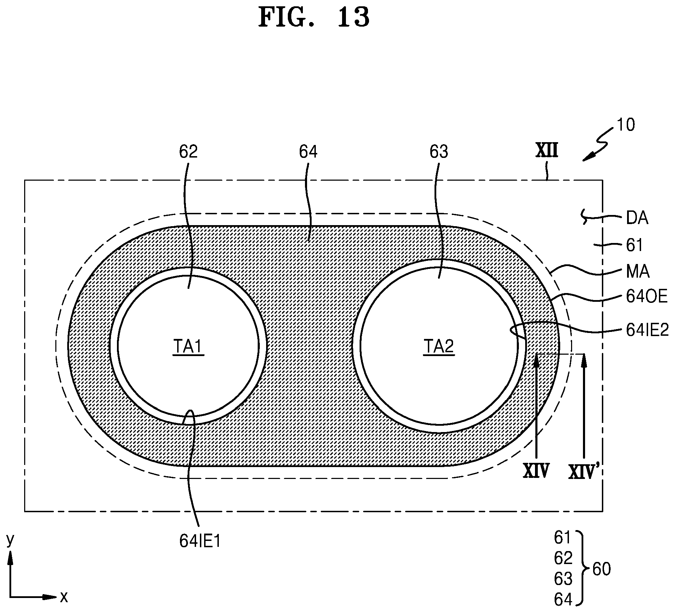

FIG. 12 is a plan view schematically showing an embodiment of the display panel 10, and FIG. 13 is a plan view showing a portion of the display panel 10 of FIG. 12, e.g., an excerpt of a region XII.

As described above with reference to FIG. 2, the display panel 10 may include the cover window 60. The cover window 60 may include a light-transmitting portion and a light-shielding portion, which correspond to the peripheral area PA. The light-transmitting portion of the cover window 60 may overlap the first and second transmission areas TA1 and TA2 , the display area DA of the display panel 10. The light-shielding portion of the cover window 60 may overlap the intermediate area MA and the peripheral area PA.

The cover window 60 may include a first light-transmitting portion 61 overlapping the display area DA, and second and third light-transmitting portions 62 and 63 respectively overlapping the first and second transmission areas TA1 and TA2. The cover window 60 may further include a first light-shielding portion 64 overlapping the intermediate area MA and a second light-shielding portion 65 overlapping the peripheral area PA.

An area of the first light-shielding portion 64 of the cover window 60 may not be the same as an area of the intermediate area MA. In an embodiment, as shown in FIG. 13, the first light-shielding portion 64 may have a similar shape to a shape of the intermediate area MA, and an area of the first light-shielding portion 64 may be smaller than an area of the intermediate area MA, for example.

The first light-shielding portion 64 may include an outer edge 64OE defining a shape of the first light-shielding portion 64, and first and second inner edges 64IE1 and 64IE2. The first and second inner edges 64IE1 and 64IE2 of the first light-shielding portion 64 may have shapes of closed curves surrounding the first and second transmission areas TA1 and TA2, respectively. The outer edge 64OE of the first light-shielding portion 64 may have a shape of a closed curve surrounding the first and second inner edges 64IE1 and 64IE2 in a plan view.

A boundary between the first light-shielding portion 64 and the first light-transmitting portion 61 may be defined by the outer edge 64OE of the first light-shielding portion 64. The outer edge 64OE of the first light-shielding portion 64 may be disposed farther from the display area DA than a boundary between the intermediate area MA and the display area DA.

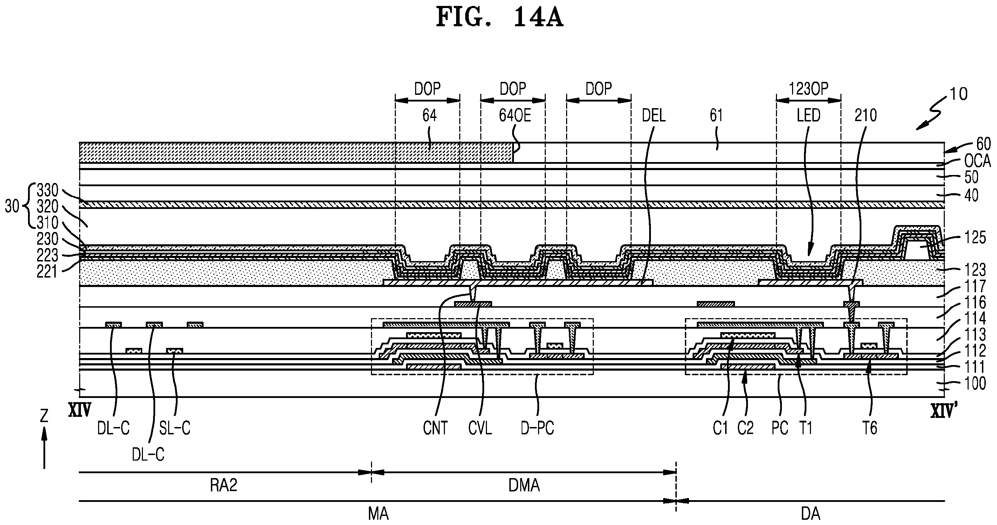

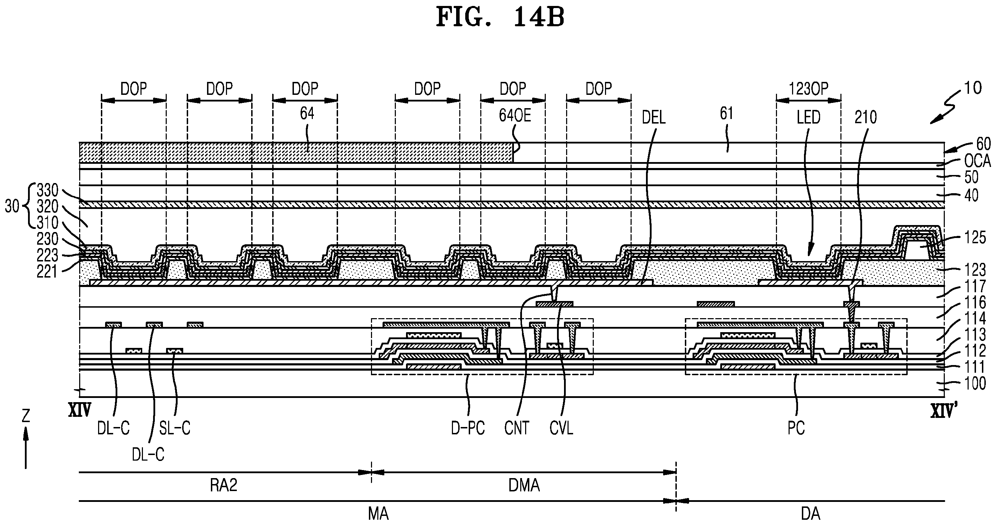

FIGS. 14A and 14B are each a cross-sectional view showing an embodiment of a portion of the display panel 10, taken along line XIV-IXV' of FIG. 13.

Referring to FIGS. 14A and 14B, the first light-shielding portion 64 of the cover window 60 may overlap a portion of the dummy electrode layer DEL disposed in the intermediate area MA, and may not overlap another portion of the dummy electrode layer DEL. The first light-shielding portion 64 may overlap at least one of dummy openings DOP of the bank layer 123 defined in the intermediate area MA, but may not overlap other some of the dummy openings DOP. In an embodiment, the dummy openings DOP defined relatively adjacent to the display area DA among the dummy openings DOP of the bank layer 123 may not overlap the first light-shielding portion 64 of the cover window 60, and the dummy openings DOP defined relatively farther from the display area DA may overlap the first light-shielding portion 64 of the cover window 60, for example.

The first light-transmitting portion 61 of the cover window 60 may overlap the light-emitting diodes LED arranged in the display area DA and the opening 123OP of the bank layer 123. The first light-transmitting portion 61 may overlap a portion of the dummy electrode layer DEL disposed adjacent to the display area DA and some of the dummy openings DOP of the bank layer 123.

The first light-shielding portion 64 of the cover window 60 may overlap detouring portions of a signal line passing the intermediate area MA. In an embodiment, as shown in FIG. 14A, the detouring portion DL-C of the data line and the detouring portion SL-C of the scan line, which pass the second routing area RA2 may overlap the first light-shielding portion 64 and the bank layer 123 (e.g., an organic material of the bank layer 123). In another embodiment, as shown in FIG. 14B, the detouring portion DL-C of the data line and the detouring portion SL-C of the scan line, which pass the second routing area RA2 may overlap the first light-shielding portion 64 of the cover window 60 while overlapping the dummy openings DOP of the bank layer 123.

In the embodiments described with reference to FIGS. 13, 14A, and 14B, the first light-shielding portion 64 overlaps the dummy openings DOP therebelow in the intermediate area MA, but the disclosure is not limited thereto. FIGS. 14A and 14B illustrate a portion of the intermediate area MA and a portion of the display area DA around the second transmission area TA2 of FIG. 13, but the disclosure is not limited thereto. Structures of a portion of the intermediate area MA and a portion of the display area DA around the first transmission area TA1 may be substantially the same as the structure of the embodiment described with reference to FIGS. 14A and 14B.

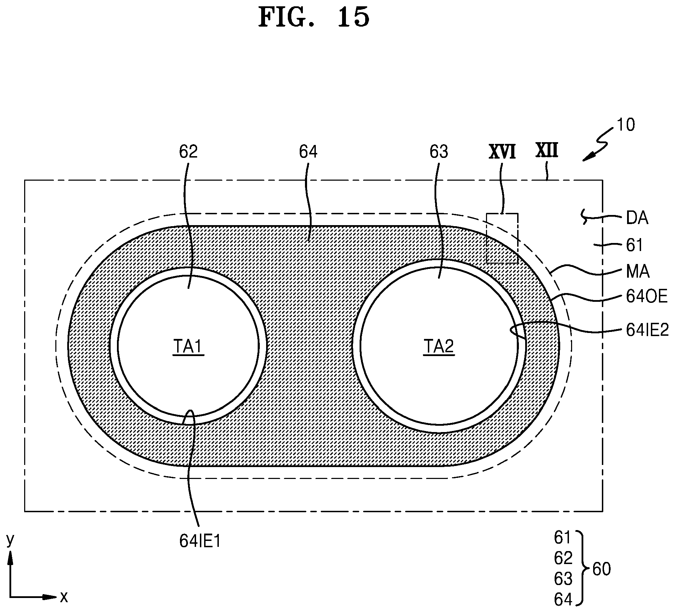

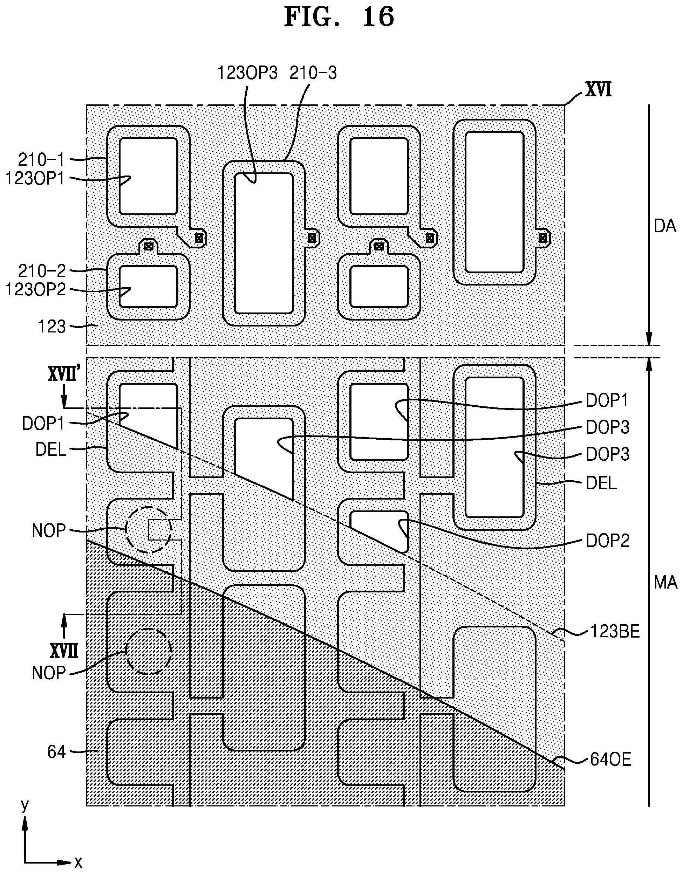

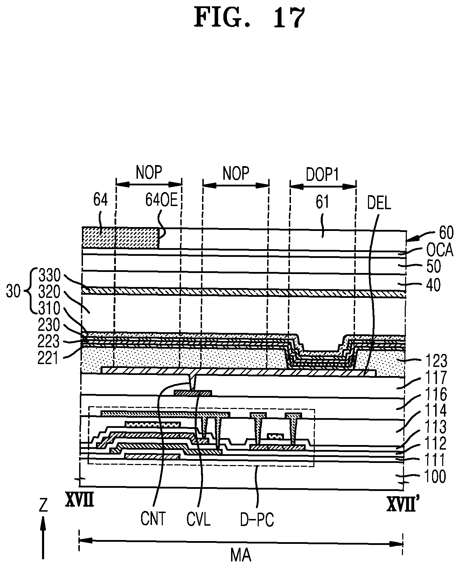

FIG. 15 is a plan view schematically illustrating an embodiment of a portion of the display panel 10, e.g., a region XII of FIG. 12, FIG. 16 is a plan view showing an excerpt of a region XVI of FIG. 15, and FIG. 17 is a cross-sectional view of the region XVI of FIG. 16 taken along line XVII-XVII' of FIG. 16.

As shown in FIG. 15, the outer edge 64OE of the first light-shielding portion 64 is disposed in the intermediate area MA, but a dummy opening may not be defined below the first light-shielding portion 64.

As shown in FIGS. 16 and 17, a dummy opening may not be below the first light-shielding portion 64. In an embodiment, a dummy opening may not be on a portion of the dummy electrode layer DEL disposed below the first light-shielding portion 64, for example. As shown in FIG. 17, the dummy electrode layer DEL may include a cover portion (or a non-opening portion NOP) entirely covered by the bank layer 123.

A portion of the cover portion NOP of the dummy electrode layer DEL may overlap the first light-shielding portion 64, and another portion of the cover portion NOP may overlap the first light-transmitting portion 61 while not overlapping the first light-shielding portion 64.

As shown in FIG. 16, dummy openings overlapping the first light-transmitting portion 61 may be defined in the bank layer 123, and shapes of the dummy openings may be different from each other. In an embodiment, one first dummy opening DOP1 may have a shape and a size different from those of another first dummy opening DOP1, and one third dummy opening DOP3 may have a shape and a size different from those of another third dummy opening DOP3, for example.

As shown in FIG. 16, a shape of a dummy opening may define a virtual boundary 123BE of the bank layer 123 passing the intermediate area MA. The virtual boundary 123BE of the bank layer 123 may be defined by edges of dummy openings. In other words, a shape and a size of a dummy opening through which the virtual boundary 123BE of the bank layer 123 passes may be different from a shape and a size of a dummy opening spaced apart from the virtual boundary 123BE of the bank layer 123.

A shape of the first dummy opening DOP1 through which the virtual boundary 123BE of the bank layer 123 passes may be different from a shape of another first dummy opening DOP1 spaced apart from the virtual boundary 123BE of the bank layer 123 in the intermediate area MA, and a shape of the first opening 123OP1 defined in the display area DA. A size of the first dummy opening DOP1 through which the virtual boundary 123BE of the bank layer 123 passes may be smaller than a size of another first dummy opening DOP1 spaced apart from the virtual boundary 123BE of the bank layer 123 in the intermediate area MA, and smaller than a size of the first opening 123OP1 defined in the display area DA.

A shape and a size of one first dummy opening DOP1 spaced apart from the virtual boundary 123BE of the bank layer 123 in the intermediate area MA may be the same as a shape and a size of the first opening 123OP1 defined in the display area DA. A shape and a size of the first dummy opening DOP1 through which the virtual boundary 123BE of the bank layer 123 passes may be different from a shape and a size of the first dummy opening DOP1. In an embodiment, a size of the first dummy opening DOP1 through which the virtual boundary 123BE of the bank layer 123 passes may be smaller than a size of the first dummy opening DOP1, for example.

A shape and a size of the second dummy opening DOP2 through which the virtual boundary 123BE of the bank layer 123 passes may be different from a shape and a size of the second dummy opening DOP2 defined in the display area DA. In an embodiment, a size of the second dummy opening DOP2 through which the virtual boundary 123BE of the bank layer 123 passes may be smaller than a size of the second dummy opening DOP2 defined in the display area DA, for example. A shape of the second dummy opening DOP2 through which the virtual boundary 123BE of the bank layer 123 passes may be different from a shape of another second dummy opening (not shown) spaced apart from the virtual boundary 123BE of the bank layer 123 in the intermediate area MA.

A shape and a size of the third dummy opening DOP3 through which the virtual boundary 123BE of the bank layer 123 passes may be different from a shape and a size of another third dummy opening DOP3 spaced apart from the virtual boundary 123BE of the bank layer 123 in the intermediate area MA, and a shape and a size of the third opening 123OP3 defined in the display area DA. A size of the third dummy opening DOP3 through which the virtual boundary 123BE of the bank layer 123 passes may be smaller than a size of another third dummy opening DOP3 spaced apart from the virtual boundary 123BE of the bank layer 123 in the intermediate area MA and smaller than a size of the third opening 123OP3 defined in the display area DA. A shape and a size of another third dummy opening DOP3 spaced apart from the virtual boundary 123BE of the bank layer 123 in the intermediate area MA may be the same as a shape and a size of the third opening 123OP3 defined in the display area DA. FIGS. 16 and 17 illustrate a portion of the intermediate area MA and a portion of the display area DA around the second transmission area TA2, which correspond to the region XVI of FIG. 15, but the disclosure is not limited thereto. Structures of a portion of the intermediate area MA and a portion of the display area DA around the first transmission area TA1 may be substantially the same as the structure of the embodiment described with reference to FIGS. 16 and 17.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the spirit and scope as defined by the following claims.

## Claims

1. A display panel comprising:
a substrate in which a transmission area, a dummy area surrounding the transmission area, and a display area surrounding the dummy area are defined;
a driving circuit disposed in the display area and including a transistor;
a voltage line disposed in the display area and electrically connected to the driving circuit;
an insulating layer on the voltage line;
a first pixel electrode disposed on the insulating layer, in the display area;
a bank layer covering an edge of the first pixel electrode, the bank layer defining a first opening overlapping the first pixel electrode;
an emission layer overlapping the first pixel electrode through the first opening of the bank layer;
an opposing electrode disposed on the emission layer and overlapping the first pixel electrode and the emission layer; and
a dummy electrode layer disposed on the insulating layer, in the dummy area,
wherein the bank layer extends towards the dummy area and defines a plurality of dummy openings overlapping the dummy electrode layer

2. The display panel of claim 1, further comprising a dummy transistor disposed below the dummy electrode layer,
wherein the dummy electrode layer is electrically insulated from the dummy transistor.

3. The display panel of claim 1, wherein the voltage line extends towards the dummy area and a portion of the voltage line overlaps the dummy electrode layer, and
the dummy electrode layer is electrically connected to the voltage line.

4. The display panel of claim 3, wherein the voltage line has a same voltage level as a voltage level of the opposing electrode.

5. The display panel of claim 3, wherein the driving circuit further includes an initialization transistor which is electrically connected to the first pixel electrode and initializes the first pixel electrode, and
the voltage line is electrically connected to the initialization transistor.

6. The display panel of claim 1, wherein the plurality of dummy openings of the bank layer includes a first dummy opening, a second dummy opening, and a third dummy opening, which overlap different portions of the dummy electrode layer, respectively.

7. The display panel of claim 6, further comprising:
a second pixel electrode disposed on the insulating layer, in the display area, and adjacent to the first pixel electrode while being mutually separated from the first pixel electrode; and
a third pixel electrode disposed on the insulating layer, in the display area, and adjacent to the first pixel electrode and the second pixel electrode while being mutually separated from the first pixel electrode and the second pixel electrode,
wherein the bank layer further defines a second opening and a third opening, wherein the second opening overlaps the second pixel electrode, and the third opening overlaps the third pixel electrode,
the first opening and the second opening are defined in a same column, and the third opening is defined adjacent to the column of the first opening and the second opening, and
the first dummy opening and the second dummy opening are defined in a same column, and the third dummy opening is defined adjacent to the column of the first dummy opening and the second dummy opening.

8. The display panel of claim 7, wherein a size of the first dummy opening and a size of the first opening are substantially same as each other,
a size of the second dummy opening and a size of the second opening are substantially same as each other, and
a size of the third dummy opening and a size of the third opening are substantially same as each other.

9. The display panel of claim 7, wherein a size and a shape of the first dummy opening are different from a size and a shape of the first opening.

10. The display panel of claim 6, wherein a routing area is further defined between the transmission area and the dummy area in the substrate and surrounds the transmission area,
wherein the dummy electrode layer extends towards the routing area, and the bank layer further defines a fourth dummy opening, a fifth dummy opening, and a sixth dummy opening, which overlap different portions of the dummy electrode layer arranged in the routing area, respectively.

11. The display panel of claim 10, wherein a size of the first dummy opening,
a size of the second dummy opening, and a size of the third dummy opening are different from each other,
a size of the fourth dummy opening and the size of the first dummy opening are substantially same as each other,
a size of the fifth dummy opening and the size of the second dummy opening are substantially same as each other, and
a size of the sixth dummy opening and the size of the third dummy opening are substantially same as each other.

12. The display panel of claim 10, wherein in the routing area, the dummy electrode layer does not overlap the transistor.

13. The display panel of claim 10, further comprising a signal line electrically connected to the driving circuit,
wherein the signal line detours along an edge of the transmission area, in the routing area, and
the dummy electrode layer overlaps a detouring portion of the signal line, in the routing area.

14. The display panel of claim 1, wherein the bank layer includes a light-shielding material.

15. An electronic apparatus comprising:
a display panel in which a transmission area, a dummy area surrounding the transmission area, and a display area surrounding the dummy area are defined, the display panel comprising:
a driving circuit disposed in the display area and including a transistor;
a voltage line disposed in the display area and electrically connected to the driving circuit;
an insulating layer on the voltage line;
a first pixel electrode disposed on the insulating layer, in the display area;
a bank layer covering an edge of the first pixel electrode and including a first opening overlapping the first pixel electrode;
an emission layer overlapping the first pixel electrode through the first opening of the bank layer;
an opposing electrode disposed on the emission layer and overlapping the first pixel electrode and the emission layer; and
a dummy electrode layer disposed on the insulating layer, in the dummy area; and
a component overlapped with the transmission area of the display panel,
wherein the bank layer extends towards the dummy area and includes a plurality of dummy openings overlapping the dummy electrode layer.

16. The electronic apparatus of claim 15, wherein the display panel further comprises a dummy transistor disposed below the dummy electrode layer, wherein the dummy electrode layer is electrically insulated from the dummy transistor.

17. The electronic apparatus of claim 15, wherein the voltage line extends towards the dummy area, and a portion of the voltage line overlaps the dummy electrode layer, and
the dummy electrode layer is electrically connected to the voltage line.

18. The electronic apparatus of claim 17, wherein the voltage line has a same voltage level as a voltage level of the opposing electrode.

19. The electronic apparatus of claim 17, wherein the driving circuit includes an initialization transistor electrically which is connected to the first pixel electrode and initializes the first pixel electrode, and
the voltage line is electrically connected to the initialization transistor.

20. The electronic apparatus of claim 15, wherein the plurality of dummy openings of the bank layer include a first dummy opening, a second dummy opening, and a third dummy opening, which overlap different portions of the dummy electrode layer, respectively.

21. The electronic apparatus of claim 20, wherein the display panel further comprises:
a second pixel electrode disposed on the insulating layer, in the display area, and adjacent to the first pixel electrode while being mutually separated from the first pixel electrode; and
a third pixel electrode disposed on the insulating layer, in the display area, and adjacent to the first pixel electrode and the second pixel electrode while being mutually separated from the first pixel electrode and the second pixel electrode,
wherein the bank layer further defines a second opening and a third opening, wherein the second opening overlaps the second pixel electrode, and the third opening overlaps the third pixel electrode,
the first opening and the second opening are defined in a same column, and the third opening is defined adjacent to the column of the first opening and the second opening, and
the first dummy opening and the second dummy opening are defined in a same column, and the third dummy opening is defined adjacent to the column of the first dummy opening and the second dummy opening.

22. The electronic apparatus of claim 21, wherein a size of the first dummy opening and a size of the first opening are substantially same as each other,
a size of the second dummy opening and a size of the second opening are substantially same as each other, and
a size of the third dummy opening and a size of the third opening are substantially same as each other.

23. The electronic apparatus of claim 21, wherein a size and a shape of the first dummy opening are different from a size and a shape of the first opening.

24. The electronic apparatus of claim 20, wherein a routing area is further defined between the transmission area and the dummy area in the display panel and surrounds the transmission area,
wherein the dummy electrode layer extends towards the routing area, and the bank layer further includes a fourth dummy opening, a fifth dummy opening, and a sixth dummy opening, which overlap different portions of the dummy electrode layer arranged in the routing area, respectively.

25. The electronic apparatus of claim 24, wherein a size of the first dummy opening, a size of the second dummy opening, and a size of the third dummy opening are different from each other,
a size of the fourth dummy opening and the size of the first dummy opening are substantially same as each other,
a size of the fifth dummy opening and the size of the second dummy opening are substantially same as each other, and
a size of the sixth dummy opening and the size of the third dummy opening are substantially same as each other.

26. The electronic apparatus of claim 24, wherein in the routing area, the dummy electrode layer does not overlap the transistor.

27. The electronic apparatus of claim 24, further comprising a signal line electrically connected to the driving circuit,
wherein the signal line detours along an edge of the transmission area, in the routing area, and
the dummy electrode layer overlaps a detouring portion of the signal line, in the routing area.

28. The electronic apparatus of claim 15, wherein the display panel further comprises:
an encapsulation layer on the opposing electrode; and
a cover window on the encapsulation layer,
wherein the cover window includes a light-shielding portion overlapping at least one dummy opening of the plurality of dummy openings defined in the dummy area, and a light-transmitting portion overlapping at least one of remaining dummy openings of the plurality of dummy openings.

29. The electronic apparatus of claim 15, wherein the component comprises a sensor or a camera.

30. The electronic apparatus of claim 15, wherein the bank layer includes a light-shielding material.
